# EUROPEAN PATENT SPECIFICATION

(11) **EP 1 691 590 B1**
(45) Date of publication and mention of the grant of the patent: **03.11.2010**
(21) Application number: 06002669.7
(22) Date of filing: 09.02.2006
(51) Int. Cl.: H05K 1/18, H01G 4/224

(54) **Wiring board**
Leiterplatte
Carte imprimée

(30) Priority: 09.02.2005 JP 2005033558; 09.02.2005 JP 2005033559; 12.07.2005 JP 2005203181
(43) Date of publication of application: 16.08.2006
(60) Divisional application: 10158476.1
(73) Proprietor: NGK Spark Plug Co., Ltd., Nagoya-shi, Aichi-ken (JP)
(72) Inventor: Muramatsu, Masaki, Komaki city, Aichi (JP); Yuri, Shinji, Kasugai city, Aichi (JP); Urashima, Kazuhiro, Kounan city, Aichi (JP); Yamamoto, Hiroshi, Konan, Aichi (JP); Seki, Toshitake, Fuso, Niwa, Aichi (JP); Sato, Motohiko, Konan, Aichi (JP)
(74) Representative: Zimmermann, Gerd Heinrich

(56) References cited:
- EP-A- 1 041 631
- US-A1- 2002 071 256
- US-A1- 2002 080 550
- US-B1- 6 453 527
- US-B1- 6 734 534
- PATENT ABSTRACTS OF JAPAN vol. 2003, no. 12, 5 December 2003 (2003-12-05) & JP 2005 019572 A (NGK SPARK PLUG CO LTD), 20 January 2005 (2005-01-20)

## Description

### Technical Field

The present invention relates to a wiring board and a capacitor to be built into the wiring board.

### Related Background Art

In recent years, semiconductor integrated circuit elements such as CPUs and the other LSIs which operate at high speed are increasingly downsized, and thus the number of signal terminals, power source terminals or ground terminals is increasing, and a distance between terminals is reducing. A technique such that a terminal array of an integrated circuit where a lot of terminals huddle is connected to a mother board in a flip-chip form is popularized, but gaps between terminals are greatly different between a terminal array on the integrated circuit and a terminal array on the mother board, and thus a wiring board as an intermediate board for eliminating this difference is required.

So-called organic package boards in such intermediate boards have wiring laminated portions where dielectric layers and conductor layers made of macromolecular material are laminated alternately, and a terminal array for flip-chip connection is arranged on a first main surface formed by the dielectric layer of the wiring laminated portion. The wiring laminated portion is formed on a board core which is mainly made of macromolecular material such as epoxy resin reinforced by glass fiber. When a terminal gap on the IC side is greatly different from a terminal gap on a side of a main board (mother board) to be the connecting destination, wiring for conversion and a provision pattern of via tend to be miniaturized and complicated in connection with an increase in the number of terminals. The organic package boards, however, have an advantage such that the miniaturized and complicated wiring pattern can be formed easily with high definition by the combination of a photolithography technique and a plating technique.

In the organic package boards, however, a main board (for example, mother board) to be the connecting destination is mainly made of a macromolecular material, and further a composing material of the organic package boards is mainly made of a macromolecular material. For this reason, if heat history such as soldering reflow is added, a difference in linear coefficient of expansion between a semiconductor integrated circuit element which is mainly made of silicon (the linear coefficient of expansion is, for example, 2 to 3 ppm/°C) and the main board (the linear coefficient of expansion is, for example, 17 to 18 ppm/°C) is not sufficiently absorbed, thereby possibly causing a defect such as soldering peeling.

On the other hand, Japanese Patent Application Laid-Open No. 2001-035966 or the like discloses a ceramic package board where a main material of the board is ceramic. When such a ceramic package board is used, the great gap of the linear coefficient of expansion between the semiconductor integrated circuit element and the main board which are flip-chip connected can be filled, thereby effectively preventing particularly a defect such that a soldered joint portion between the semiconductor integrated circuit element and the terminals is broken due to thermal stress.

In the ceramic package boards, however, since a wiring portion is formed by using printing and calcining of metal paste, it is more difficult that the wiring portion is miniaturized and highly integrated than organic package boards which can utilize the lithography technique, and thus a reduction in the terminal gap on the side of the semiconductor integrated circuit element is limited. A multistage board connecting structure, where a first intermediate board composed of an organic package board is connected to a main board, a second relay board made of ceramic is connected to the first intermediate board and a semiconductor integrated circuit element is connected to the second relay board, can be considered. In this structure, however, it is difficult to comply with a requirement of downsizing because a dimension of the board connecting structure in a heightwise (vertical) direction is increased by an increase in the number of the intermediate boards, and the number of connecting steps also increases. For this reason, the multistage board connecting structure is insufficient.

An intermediate substrate with a built-in capacitor is described in JP 2005-019572. The intermediate substrate comprises a core body in which a sub-core containing part is formed to accommodate a ceramic sub-core therein.

EP 1 041 631 describes a capacitor-built-in-type printed substrate.

US 6 734 534 describes a microelectronic substrate with at least one microelectronic die disposed within an opening in a microelectronic substrate core.

### SUMMARY OF THE INVENTION

It is an object of the present invention to provide a wiring board where disconnection or the like due to thermal stress hardly occurs, a height of an entire board connecting structure can be reduced easily and the number of connecting steps can be reduced. Further, it is an object of the present invention to provide a capacitor to be built into the wiring board.

These objects are solved by the wiring boards according to claims 1 and 2.

A first wiring board of the present invention includes:
a board core that is composed of a core main body formed into a plate shape by a macromolecular material (includes a material which is compounded with filler such as ceramic fiber or particles) and a sub-core portion, the core main body being formed with a sub-core housing portion which is opened and formed by reducing a thickness of the core main body on a first main body, the sub-core portion being formed into a plate shape by a material with smaller linear coefficient of expansion than the core main body and being housed in the sub-core housing portion with its thicknesswise direction (perpendicular with respect to the lateral extent of the plate shape of the core main body) being matched with that of the core main body;
a filling coupled portion that is made of a macromolecular material which fills a gap between an inner peripheral surface of the sub-core housing portion and an outer peripheral surface of the sub-core portion;
a first terminal array that is formed on the first main surface of the board core, and is composed of a first side first type terminal and a first side second type terminal, one of which serves as a power source terminal and the other of which serves as a ground terminal, and a first side signal terminal; and
a second terminal array that is formed on a second main surface of the board core, and is composed of a second side first type terminal and a second side second type terminal which are conductive with the first side first type terminal and the second type terminal, respectively, and a second side signal terminal which is conductive with the first side signal terminal,
wherein the first terminal array is formed in a position where it overlaps a projection area of the sub-core portion in orthographic projection to a reference surface parallel with a plate surface of the board core,
wherein the sub-core portion incorporates a laminated capacitor where a first electrode conductor layer which is conductive with the first side first type terminal and the second side first type terminal, a dielectric layer, and a second electrode conductor layer which is conductive with the first side second type terminal and the second side first type terminal are laminated in this order,
wherein the sub-core housing portion has an inner peripheral edge of a cross section along the plane parallel with the plate surface of the sub-core portion whose shape is quadrate, and a radius portion or a chamfered portion with dimension of not less than 0.1 mm to not more than 2 mm is formed on its corners.

A second wiring board includes:
a board core that is composed of a core main body formed into a plate shape by a macromolecular material (includes a material which is compounded with filler such as ceramic fiber or particles) and a sub-core portion, the core main body being formed with a sub-core housing portion which is opened and formed by reducing a thickness of the core main body on a first main body, the sub-core portion being formed into a plate shape by a material with smaller linear coefficient of expansion than the core main body and being housed in the sub-core housing portion with its thicknesswise direction being matched with that of the core main body;
a filling coupled portion that is made of a macromolecular material which fills a gap between an inner peripheral surface of the sub-core housing portion and an outer peripheral surface of the sub-core portion;
a first terminal array that is formed on the first main surface of the board core, and is composed of a first side first type terminal and a first side second type terminal, one of which serves as a power source terminal and the other of which serves as a ground terminal, and a first side signal terminal; and
a second terminal array that is formed on a second main surface of the board core, and is composed of a second side first type terminal and a second side second type terminal which are conductive with the first side first type terminal and the second type terminal, respectively, and a second side signal terminal which is conductive with the first side signal terminal,
wherein the first terminal array is formed in a position where it overlaps a projection area of the sub-core portion in orthographic projection to a reference surface parallel with a plate surface of the board core,
wherein the sub-core portion incorporates a laminated capacitor where a first electrode conductor layer which is conductive with the first side first type terminal and the second side first type terminal, a dielectric layer, and a second electrode conductor layer which is conductive with the first side second type terminal and the second side first type terminal are laminated in this order,
wherein the sub-core housing portion has an inner peripheral edge of a cross section along the plane parallel with a plate surface of the sub-core portion which is composed of only a curved portion with curvature radius of not less than 0.1 mm which is convex outward.

According to the constitution, the sub-core portion, which is made of a material with smaller linear coefficient of expansion than that of the core main body made of the macromolecular material, is embedded into the board core so as to overlap the area of the first terminal array to be flip-chip connected to a semiconductor integrated circuit element. For this reason, a difference in linear coefficient of expansion between the terminals in the first terminal array and the semiconductor integrated circuit element can be sufficiently reduced, and thus disconnection or the like due to thermal stress can be greatly suppressed. Since the sub-core portion corresponding to a second wiring board is embedded into the core main body corresponding to a first wiring board, the height of the entire connected structure between the semiconductor integrated circuit element and a main board using the wiring boards can be lowered, and the number of connecting steps can be reduced. The capacitor which serves as a decoupling capacitor (or pass capacitor) can be directly connected to the semiconductor element in a form of the wiring board, so that the decoupling capacitor can be close to the semiconductor element. As a result, a length of the wiring between the power source terminal and the decoupling capacitor can be shortened, and since inductance of the capacitor terminal portion can be reduced, thereby contributing to low impedance of the decoupling capacitor. Since the decoupling capacitor is incorporated into the wiring board, it is not necessary to arrange the decoupling capacitor as separate element on a rear surface of the main board, thereby reducing the number of parts or downsizing the device.

In any constitution of the present invention, the sub-core portion and the core main body are coupled by the filling coupled portion made of a macromolecular material that fills the gap between the inner peripheral surface of the sub-core housing portion and the outer peripheral surface of the sub-core portion. When all inner edge corners of the sub-core housing portion are formed into right angle, namely, 90° (so-called, pin corner), the filling coupled portion which is put thereinto also has protrusion corners at right angle on its four corners according to the sub-core housing portion. When the sub-core housing portion is filled with the filling coupled portion and the filling coupled portion is solidified by a liquid macromolecular material, fine air bubbles are occasionally formed near the protruded corners. A crack occasionally occurs near the protruded corners of the filling coupled portion at the time of heat cycle test or the like. When such a crack and air bubbles occur, adhesion of the sub-core portion and the filling coupled portion is deteriorated, thereby breaking the wiring boards and hindering formation of a build-up resin insulating layer to be provided on the core main body and the sub-core portion.

According to the first aspect of the first invention, however, a curved surface according to the radius surface of the sub-core housing portion or a tilted surface according to chamfering is formed also on the protruded corners of the filling coupled portion. For this reason, air bubbles are hardly formed in the macromolecular material near the protruded corners, and concentricity of stress can be avoided even if temperature history is added, thereby making occurrence of crack or the like difficult. The adhesion between the sub-core portion and the filling coupled portion is, therefore, secured, and defects such that the wiring boards are accidentally broken and the formation of the build-up resin insulating layer is hindered can be effectively prevented. When the dimension of the radius portion or the chamfered portion (in the former one, curvature radius, and in the latter one, chamfering dimension in a longitudinal direction of the wiring board) is less than 0.1 mm, the protruded corners of the filling coupled portion become too narrow, air bubbles and crack easily occur. On the other hand, when the dimension of the radius portion and the chamfered portion exceeds 2 mm, the effect for preventing the defects is occasionally saturated.

On the other hand, according to the second aspect of the present invention, the inner edge of the sub-core housing portion is composed of only a curved portion with curvature radius of not less than 0.1 mm which is convex outward. For this reason, the protruded corners where residual bubbles or the like easily occur are hardly formed on the filling coupled portion and the concentricity of stress can be avoided even if temperature history is added, thereby hardly causing a crack or the like. The adhesion between the sub-core portion and the filling coupled portion is, therefore, secured, and thus defects such that the wiring boards are accidentally broken and the formation of the build-up resin insulating layer is hindered can be effectively prevented. In the second aspect of the invention, that "the inner edge of the sub-core housing portion is composed only of the curved portion with curvature radius of not less than 0.1 mm which is convex outward" is equivalent to that "a curved portion with curvature radius of less than 0.1 mm" is eliminated from configurational components of the inner edge of the sub-core housing portion. The concept such of "the curved portion with curvature radius of less than 0.1 mm" includes "a pin corner portion with curvature radius of less than 0.1 mm". The second aspect of the invention is particularly effective when the inner peripheral edge of the cross section of the sub-core housing portion is formed into a circular shape.

Requirements which can be added and are common between the first and second aspects of the present invention are explained below.

In the sub-core portion, the outer peripheral edge of the cross section along a plane parallel with a plate surface of the sub-core portion can have a quadrate shape, and a radius portion or a chamfered portion with dimension of not less than 0.1 mm to not more than 2 mm can be formed on its corners. When the corners of the sub-core portion are pin corners, back stress from the sub-core portion is easily concentrated onto the corners of the filling coupled portion at the time of adding temperature history, and thus crack occasionally occurs easily. Further, crack easily occurs on the filling coupled portion from the corner ends of the sub-core portion. When, however, the radius portion or the chamfered portion is formed on the corners of the sub-core portion, the concentricity of stress to the corners of the filling coupled portion can be suppressed more easily. Occurrence of crack originated from the corner ends of the sub-core portion can be suppressed effectively.

The first terminal array can be formed in a position where it is entirely included in a projection area of the sub-core portion in orthographic projection to a reference surface parallel with the plate surface of the board core. According to this constitution, the sub-core portion, whose dimension is adjusted so that the entire first terminal array to be flip-chip connected to the semiconductor integrated circuit element is included, is embedded into the board core. For this reason, a difference in linear coefficient of expansion between all the terminals in the first terminal array and the semiconductor integrated circuit element can be reduced sufficiently, and thus disconnection or the like due to thermal stress can be further suppressed. Since the sub-core portion corresponding to the second wiring board is embedded into the core main body corresponding to the first wiring board, the height of the entire connected structure of the semiconductor integrated circuit element and the main board using the intermediate boards can be lowered, and the number of connecting steps can be reduced. A capacitor which serves as a decoupling capacitor (or pass capacitor) can be directly connected to the semiconductor element in a form of the intermediate board, and thus the decoupling capacitor can be close to the semiconductor element. As a result, a length of the wiring between the power source terminal and the decoupling capacitor can be shortened, and inductance of the capacitor terminal can be reduced, thereby contributing to lowering of impedance of the decoupling capacitor. Further, since the decoupling capacitor is incorporated into the intermediate board, it is not necessary to arrange the decoupling capacitor as separate element on a rear surface of the main board, thereby reducing the number of parts and downsizing the device. This effect is particularly remarkable when the sub-core portion is formed so as to have the equivalent or larger area than that of the forming area of the first terminal array.

A material of the sub-core portion is not particularly limited as long as its linear coefficient of expansion is smaller than that of the core main body. When it is taken into consideration that the linear coefficient of expansion of the macromolecular material is comparatively high, however, it is very convenient that the sub-core portion is a ceramic sub-core portion mainly made of ceramic from the viewpoint such that the effect for reducing the difference in linear coefficient of expansion between the sub-core portion and the semiconductor integrated circuit element is remarkably achieved.

In this case, examples of the ceramic composing the sub-core portion are alumina (7 to 8 ppm/°C) and glass ceramic (a kind of composite material where 40 to 60 parts by weight of inorganic ceramic filler such as alumina is added to borosilicate glass or lead borosilicate glass). The former one has relatively small linear coefficient of expansion in various ceramics, and produces the excellent effect for reducing the difference in linear coefficient of expansion between the sub-core portion and the semiconductor integrated circuit element to be connected. On the other hand, the latter one is easily calcined at low temperature, and when a metal wiring portion, a via and the like are formed as the need arises, it can be calcined simultaneously with a metal material with high electric conductivity and comparatively low melting point which is mainly made of Cu and Ag.

The content of an Si component in the ceramic composing the sub-core portion is not less than 68 % by weight to not more than 99 % by weight in SiO₂ equivalent. When a cation component other than Si is composed of oxide forming cation that forms oxide whose linear coefficient of expansion is larger than that of SiO₂ within temperature range of room temperature to 200 °C, the ceramic can be composed of an oxide glass material whose average linear coefficient of expansion at room temperature to 200 °C is adjusted to not less than 1 ppm/°C to not more than 7 ppm/°C.

The linear coefficient of expansion of SiO₂ within the temperature range of room temperature to 200 °C is before and after 1 ppm/°C which is very small. When the sub-core portion is composed of the above glass material containing oxide forming cation for forming oxide whose linear coefficient of expansion is larger than 1 ppm/°C, the linear coefficient of expansion of the glass material can be freely adjusted to an arbitrary value not less than 1 ppm/°C according to a type and a content of the oxide forming cation. As a result, the sub-core portion using the glass material can reduce the difference in linear coefficient of expansion with the semiconductor integrated circuit element to be packaged as much as possible, and can greatly improve reliability of the terminal connected state with the semiconductor integrated circuit element by flip-chip connection or the like.

In the case where the semiconductor integrated circuit element to be connected is an Si semiconductor part, since the linear coefficient of expansion of Si is before and after 3 ppm/°C, it is desirable that the linear coefficient of expansion of the oxide glass material is adjusted to not less than 1 ppm/°C to not more than 6 ppm/°C, particularly not less than 2 ppm/°C to not more than 5 ppm/°C. On the other hand, in the case where the semiconductor integrated circuit element to be connected is a compound semiconductor part composed of III-V compound to be matched to GaAs, since the linear coefficient of expansion of the semiconductor is about 5 to 6 ppm/°C, it is desirable that the linear coefficient of the oxide glass material is adjusted to not less than 4 ppm/°C to not more than 7 ppm/°C. In any cases, thermal shear stress based on the difference in linear coefficient of expansion between parts and boards is hardly exerted on the terminal connected structure with the semiconductor integrated circuit element packaged onto the sub-core portion, thereby greatly reducing an incidence rate of defects such as disconnection.

In this case, when the content of SiO₂ in the oxide glass material composing the sub-core portion is less than 68 % by weight, it is difficult to suppress the linear coefficient of expansion of the glass material to not more than 7 ppm/°C, and thus a difference in linear coefficient of expansion between the sub-core portion and the semiconductor part cannot be sufficiently reduced. When the content exceeds 99 % by weight, glass melting point rises, and production cost of good-quality glass with less residual bubbles increases. It is occasionally difficult to maintain the linear coefficient of expansion of the glass material at not less than 1 ppm/°C.

### BRIEF DESCRIPTION OF THE DRAWINGS

Fig. 1 is a side pattern diagram illustrating one example of a usage of an intermediate board according to the present invention;
Fig. 2 is an equivalent circuit diagram illustrating one example of a usage of a decoupling capacitor for an integrated circuit;
Fig. 3 is a plan view illustrating one example of an arrangement form of a first terminal array of the intermediate board in Fig. 1;
Fig. 4 is a sectional pattern diagram illustrating the intermediate board according to a first embodiment of the present invention;
Fig. 5 is a sectional pattern diagram illustrating the intermediate board according to a second embodiment of the present invention;
Fig. 6 is a sectional pattern diagram illustrating the intermediate board according to a third embodiment of the present invention;
Fig. 7 is a sectional pattern diagram illustrating the intermediate board according to a fourth embodiment of the present invention;
Fig. 8 is a sectional pattern diagram illustrating the intermediate board according to a fifth embodiment of the present invention;
Fig. 9 is a sectional pattern diagram illustrating the intermediate board according to a sixth embodiment of the present invention;
Fig. 10 is a sectional pattern diagram illustrating the intermediate board according to a seventh embodiment of the present invention;
Fig. 11 is a sectional pattern diagram illustrating the intermediate board according to an eight embodiment of the present invention;
Fig. 12 is a pattern diagram illustrating a plane form of an electrode conductor layer of the capacitor incorporated into the intermediate board;
Fig. 13 is a pattern diagram illustrating a first example of a sectional shape of a sub-core housing portion and the sub-core portion;
Fig. 14 is a pattern diagram illustrating a second example of the sectional shape of the sub-core housing portion and the sub-core portion;
Fig. 15 is a pattern diagram illustrating a third example of the sectional shape of the sub-core housing portion and the sub-core portion;
Fig. 16 is a pattern diagram illustrating a fourth example of the sectional shape of the sub-core housing portion and the sub-core portion;
Fig. 17 is a pattern diagram illustrating a fifth example of the sectional shape of the sub-core housing portion and the sub-core portion;
Fig. 18 is a pattern diagram illustrating a sixth example of the sectional shape of the sub-core housing portion and the sub-core portion;
Fig. 19 is a sectional pattern diagram illustrating the intermediate board according to a ninth embodiment of the present invention;
Fig. 20 is a plan view of a capacitor to be built into a wiring board according to the first embodiment;
Fig. 21 is a vertical sectional view of the capacitor to be built into the wiring board according to the first embodiment;
Fig. 22A and 22B are lateral sectional views of the capacitor to be built into the wiring board according to the first embodiment; and
Fig. 23 is a plan view of the capacitor to be built into another wiring board according to the first embodiment.

### DETAILED DESCRIPTION OF THE PREFERRED EMBODIMENTS

Embodiments of the present invention are explained below with reference to the drawings.

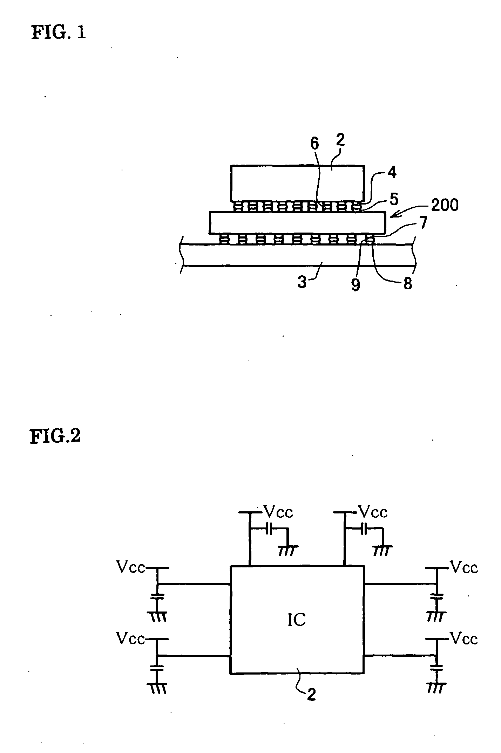

Fig. 1 illustrates an example where an intermediate board (wiring board) 200 according to a first embodiment of a wiring board of the present invention is constituted as an intermediate board which is arranged between a semiconductor integrated circuit element 2 and a main board 3. Further, first main surfaces of plate members in this embodiment are surfaces exposed upward in the drawing, and second main surfaces are surfaces exposed downward.

The semiconductor integrated circuit element 2 has an element side terminal array 4 which is composed of a plurality of signal terminals, a power source terminal and a grand terminal on the second main surface. The element side terminal array 4 is flip-chip connected to a first terminal array 5 formed on the first main surface of the intermediate board 200 via a soldering connection portion 6. On the other hand, the main board 3 is a mother board or an organic laminated package board composing the intermediate board at second stage. In both cases, the board is mainly made of macromolecular material which is reinforced by ceramic particles or fiber as filler, and the main board 3 is connected to a second terminal array 7 formed on the second main surface of the intermediate board 200 on a main board side terminal array 8 composed of soldering balls or metal pins via a soldering connection portion 9.

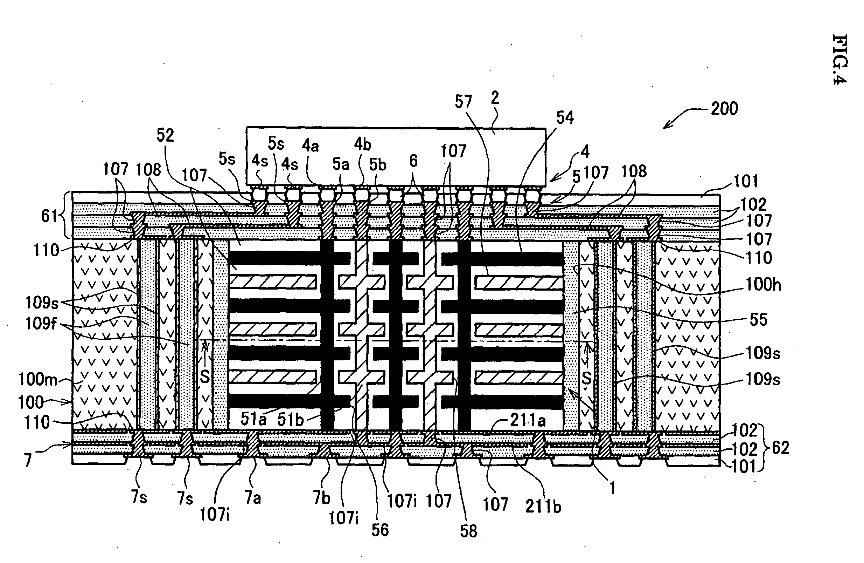

As shown in Fig. 4, the intermediate board 200 has a board core 100 which is composed of a core main body (wiring board main body) 100m and a sub-core portion 1. The core main body 100m is formed into a plate shape mainly by a macromolecular material, and is formed with a sub-core housing portion (capacitor housing portion) 100h which is opened and formed on the first main surface by reducing a thickness of the core main body 100m. The sub-core portion is formed into a plate shape by ceramic, and is housed in the sub-core housing portion 100h so that its thicknesswise direction matches with that of the core main body 100m. The first terminal array 5 is formed on the first main surface side of the board core 100. The first terminal array 5 is composed of a first side first type terminal 5a and a first side second type terminal 5b one of which serves as the power source terminal and the other one of which serves as the ground terminal, and a first side signal terminal 5s.

The first terminal array 5 is formed so as to establish a positional relationship where it is entirely included in a projection area of a sub-core portion 1 in orthographic projection to a reference surface parallel with a plate surface of the board core 100. That is to say, all the first side first type terminal 5a, the first side second type terminal 5b and the first side signal terminal 5s are flip-chip jointed to the semiconductor integrated circuit element 2 (of an element side terminal array 4) on the sub-core portion 1. As a result, a difference in linear coefficient of expansion between all the terminals in the first terminal array 5 and the semiconductor integrated circuit element 2 can be reduced sufficiently, and thus occurrence of disconnection or the like due to thermal stress can be made to be greatly difficult. In an intermediate board 200 in Fig. 4, the sub-core portion 1 has a larger area than a formed area of the first terminal array 5, and the thermal stress reducing effect is more improved.

The core main body 100m is formed into a plate shape by, for example, a heat-resistant resin plate (for example, bismaleimide-triazine resin plate), a fiber-reinforced resin plate (for example, glass fiber-reinforced epoxy resin) and the like.

Examples of the composing materials of the ceramic layer 52 composing a main portion of the sub-core portion 1 are alumina (thermal expansion coefficient: 7 to 8 ppm/°C), glass ceramic obtained by adding 40 to 60 percent by weight of inorganic ceramic filler such as alumina to borosilicate glass or lead borosilicate glass, and low-temperature calcined ceramic such as Bi₂O₃-CaO-ZnO-Nb₂O₅ ceramic. Examples of the other ceramic materials are aluminum nitride, silicon nitride, mullite, silicon dioxide and magnesium oxide. The sub-core portion 1 can be made of a composite material of, for example, a macromolecular material and ceramic (for example, the composite material of a macromolecular material and ceramic where the weight content ratio of the ceramic is higher than the core main body) as long as the condition that the linear coefficient of expansion is smaller than that of the core main body 100m is satisfied. On the other hand, as a reference technique, the sub-core portion 1 can be replaced by the sub-core portion made of silicon from the viewpoint that its linear coefficient of expansion is similar to that of a semiconductor element.

On the other hand, the ceramic composing the sub-core portion can be composed of a glass material, such as quartz glass whose skeleton component is silicon dioxide (silica, SiO₂). In this case, since physical adjustment is made suitably for applications as ceramic dielectric, various glass addition components other than SiO₂ can be mixed. As to the above glass materials, it is effective that alkali metal oxide such as Na₂O, K₂O or Li₂O, and B₂O₃ (boracic acid) are mixed as flux component from the viewpoint that flow property of molten glass is heightened and residual bubbles or the like are suppressed. On the other hand, when alkali earth metal oxide such as BaO or SrO is added, permittivity property of the glass material can be improved. Excessive addition, however, increases the linear coefficient of expansion of the glass, and thus easily causes an increase in a difference in the linear coefficient of expansion between the glass material and parts, thereby occasionally causing defective connection due to thermal stress. The flow property is remarkably reduced due to a rise in a softening point of the glass, thereby occasionally causing a defect such as residual bubbles.

An increase in the linear coefficient of expansion of the glass is effectively suppressed by heightening the content of SiO₂ component or mixing ZnO as glass addition component. Meanwhile, the oxide such as Ti, Zr or Hf effectively improves the permittivity property of the glass and water-proof property of the glass. The excessive addition, however, greatly deteriorates the flow property due to a rise in the softening point of the glass, thereby occasionally causing the defect such as residual bubbles.

In the quarts glass material (oxide glass material), the content of the Si component is not less than 68 % by weight to not more than 99 % by weight in SiO₂ equivalent. A cation component other than Si is composed of oxide forming cation that forms oxide whose linear coefficient of expansion is larger than that of SiO₂ (hereinafter, oxide for adjusting linear coefficient of expansion) in a temperature range of room temperature to 200 °C, and such oxide, whose average linear coefficient of expansion is adjusted to not less than 1 ppm/°C to not more than 7 ppm/°C at room temperature to 200°C, is adopted. As a result, the linear coefficient of expansion of the glass material can be freely adjusted to an arbitrary value of not less than 1 ppm/°C according to type and content of oxide component (the linear coefficient of expansion is larger than that of SiO₂). As a result, a difference in the linear coefficient of expansion between the sub-core portion 1 and the semiconductor part 2 to be packaged can be reduced as much as possible. In the case where the semiconductor integrated circuit element 2 is an Si semiconductor part (an average linear coefficient of expansion at room temperature to 200 °C: 3 ppm/°C), the linear coefficient of expansion of the quartz glass material is desirably adjusted to not less than 1 ppm/°C to not more than 6 ppm/°C, particularly not less than 2 ppm/°C to not more than 5 ppm/°C. On the other hand, the semiconductor integrated circuit element 2 can be composed of a compound semiconductor part made of a III-V compound which is matched to GaAs (for example, GaAs next-generation high-speed CPU and MMIC (Monolithic Microwave Integrated Circuit)), but in this case, since the linear coefficient of expansion of the semiconductor is about 5 to 6 ppm/°C, the linear coefficient of expansion of the quartz glass material is desirably adjusted to not less than 4 ppm/°C to not more than 7 ppm/°C.

Examples of oxide whose linear coefficient of expansion is larger than SiO₂ are alkali metal oxide (Na₂O, K₂O, Li₂O: 20 to 50 ppm/°C), alkali earth metal oxide (BeO, MgO, CaO, SrO, BaO: 8 to 15 ppm/°C), ZnO (6 ppm/°C), and Al₂O₃ (7 ppm/°C). The oxide may be suitably selected from them after dielectric property, a melting point and glass flow property are taken into consideration. The content of the SiO₂ is adjusted to not less than 68 % by weight to not more than 99 % by weight (preferably not less than 80 % by weight to not more than 85 % by weight) in order to set the linear coefficient of expansion within the above range, the residual portion can be composed of the above oxide for adjusting the linear coefficient of expansion.

The followings are concrete examples of glass composite which can be adopted by the present invention:

SiO₂: 80.9 % by weight, B₂O₃: 12.7 % by weight, Al₂O₃: 2.3 % by weight, Na₂O: 4.0 % by weight, K₂O: 0.04 % by weight, and Fe₂O₃: 0.03 % by weight (softening point: 821 °C, the linear coefficient of expansion (average value at 20 °C to 200 °C): 3.25 ppm/°C).

The sub-core portion 1 is entirely composed as a laminated capacitor (laminated ceramic capacitor or a capacitor to be built into a wiring board) in this embodiment. The laminated capacitor 1 is constituted so that a first electrode conductor layer 54 which is conductive with the first side first type terminal 5a and the second side first type terminal 7a, a ceramic layer 52 to be a dielectric layer, and a second electrode conductor layer 57 to be conductive with the first side second type terminal 5b and the second side second type terminal 7b are laminated in this order.

In this embodiment, the ceramic layer 52 is composed of high-permittivity ceramic which is mainly made of barium titanate (BaTiO₃). Suitable examples of the ceramic layer are perovskite compound oxide such as strontium titanate, calcium titanate and lead titanate.

In Fig. 4, the sub-core portion 1 is concretely a laminated capacitor where the first electrode conductor layer 54 which is conductive with a first type sub-core conductor 51a, the second electrode conductor layer 57 which is conductive with a second type sub-core conductor 51b, and a ceramic layer 52 which is obtained by simultaneously calcining the first electrode conductor layer 54 and the second electrode conductor layer 57 are laminated alternately. The sub-core portion 1 which is composed of such a laminated capacitor can be manufactured by using, for example, a ceramic green sheet, and the first electrode conductor layer 54 and the second electrode conductor layer 57 can be formed by printing application of metal paste. The first electrode conductor layers 54 having the same polarity or the second electrode conductor layers 57 having the same polarity are connected with each other in a laminated direction by the first type sub-core conductor 51a or the second type sub-core conductor 51b composing via, and the electrode conductor layers 54 and 57 having different polarities or the sub-core conductors 51a and 51b having different polarities are separated by through holes 56 and 58 formed on the respective electrode conductor layers 54 and 57 at the time of print-patterning of metal paste in a direct-current manner. The capacitor serves as a decoupling capacitor which is connected in parallel to the power source line of the semiconductor integrated circuit element 2 as shown in Fig. 2.

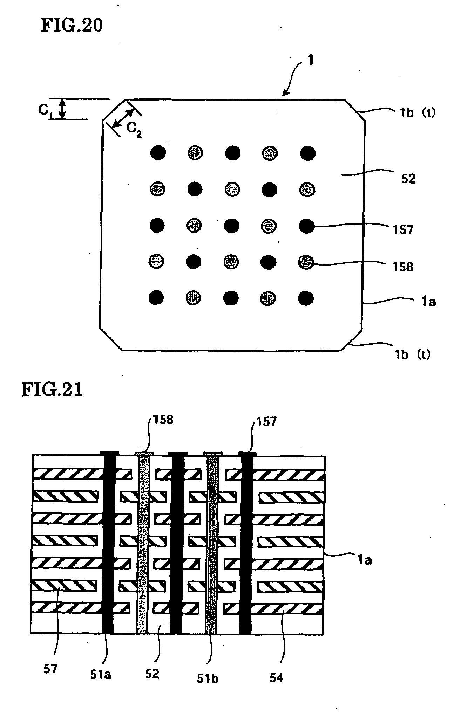

The laminated capacitor (capacitor to be built into the wiring board) 1 is explained more concretely (Figs. 20 to 23).

The laminated capacitor 1 shown in Figs. 20, 21, 22A and 22B are formed into a rectangular solid shape. It is preferable that dimensions of the laminated capacitor 1 in vertical and lateral directions are not less than 11.0 mm to not more than 13.0 mm respectively. When the laminated capacitor 1 is formed into such a dimension, it has the approximately same size as the semiconductor chip 2, mentioned later, and thus the difference in the thermal expansion between the semiconductor chip 2 and the wiring board 200 can be efficiently mitigated.

The laminated capacitor 1 is composed of a plurality of the first electrode conductor layers 54, a plurality of the second electrode conductor layers 57 which are opposed to the first electrode conductor layers 54, the ceramic layers 52 as the dielectric layers and the like. The first electrode conductor layers 54 and the second electrode conductor layers 57 are arranged alternately. The ceramic layers 52 lie between the first electrode conductor layers 54 and the second electrode conductor layers 57. The first electrode conductor layers 54 and the second electrode conductor layers 57 are electrically insulated from each other by the ceramic layers 52.

The linear coefficient of expansion of the ceramic layer 52 is smaller than the linear coefficient of expansion of the wiring board 200 mainly made of macromolecular material, and is larger than the linear coefficient of expansion of the semiconductor board of the semiconductor chip 2, mentioned later, to be mounted to the wiring board 200. In the case where the wiring board 200 is an organic board, the linear coefficient of expansion of the wiring board 200 is about 17 to 20 ppm/°C at room temperature to 300 °C. In the case where the semiconductor board of the semiconductor chip 2 is a Si board, the linear coefficient of expansion of the semiconductor board is about 3 ppm/°C at room temperature to 300 °C.

The ceramic layers 52 are formed so as to cover not only the portions between the first electrode conductor layers 54 and the second electrode conductor layers 57 but also a top layer of the electrode layer (the top layer of the electrode layer is the first electrode conductor layer 54 in Fig. 21) from above, and a bottom layer of the electrode layer (in Fig. 21, the bottom layer of the electrode layer is the first electrode conductor layer 54) from below.

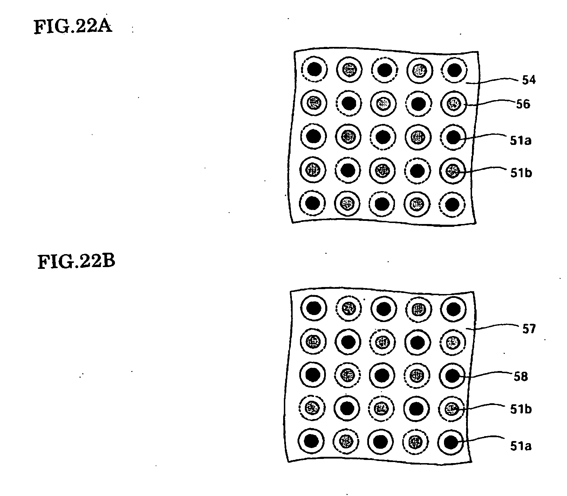

As shown in Fig. 22A, a window portion 56 is formed on an area of the first electrode conductor layer 54 where the second type sub-core conductor (second via electrode) 51b composing the via pierces, and the first electrode conductor layer 54 and the second type sub-core conductor 51b composing the via are electrically insulated from each other. Further, similarly as shown in Fig. 22B, a window portion 58 is formed on an area of the second electrode conductor layer 57 where the first type sub-core conductor (first via electrode) 51a composing the via pierces, and the second electrode conductor layer 57 and the first type sub-core conductor 51a composing the via are electrically insulated from each other.

The first type sub-core conductor 51a is electrically connected to a first terminal 157 formed on the surface of the laminated capacitor 1, and the second type sub-core conductor 51b is electrically connected to a second terminal 158 formed on the surface of the laminated capacitor 1. The first terminal 157 and the second terminal 158 are used as a power supply terminal and a ground connecting terminal. The first terminal 157 and the second terminal 158 on the surface do not have to be provided.

An outer peripheral surface 1a is a side surface other than the surface of the laminated capacitor 1 where the surface terminal is formed. Plane type chamfered portions 1b (t) with chamfering dimension C1 of not less than 0.6 mm are formed on four corners of the outer peripheral surface 1a, respectively. The chamfering dimension C1 is a length shown in Fig. 20. The chamfering dimension C1 may be actually measured, but it can be obtained from a C face length C2 of a line shown in Fig. 20. A value obtained by dividing the C face length C2 by √2 becomes the chamfering dimension C1.

The chamfered portion 1b (t) may be formed on at least one corner of the outer peripheral surface 1a of the laminated capacitor 1, but when suppression of a crack of a resin filler 12, mentioned later, is taken into consideration, it is preferable that the chamfered portion 1b (t) is formed on all the corners.

Only one chamfered portion 1b (t) whose chamfering dimension C1 is different from the other three chamfered portions 1b (t) may be formed. Instead that the chamfering dimension C1 of the only one chamfered portion 1b (t) is changed, the shape of only one chamfered portion 1b (t) may be changed.

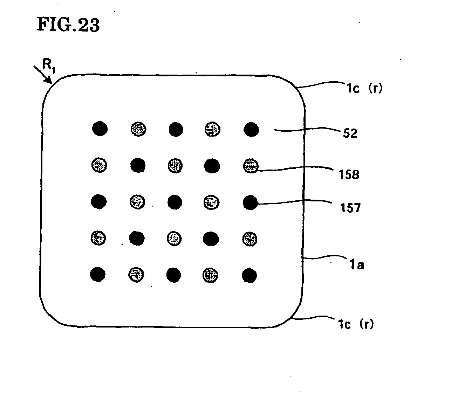

It is desirable that the chamfering dimension C1 is not less than 0.8 mm to not more than 1.2 mm from the viewpoint of the manufacturing of the laminated capacitor. As shown in Fig. 23, instead of or together with the chamfered portion 1b (t), a radius portion 1c (r) with curvature radius R1 of not less than 0.6 mm may be formed on at least one corner of the outer peripheral surface 1a of the capacitor 1. In this case, it is desirable the curvature radius R1 of the radius portion 1c (r) is not less than 0.8 mm to not more than 1.2 mm from the viewpoint of the manufacturing of the laminated capacitor. Similarly to the chamfered portion 1b (t), only one radius portion 1c (r) whose curvature radius R1 is different from the other plural radius portions 1c (r) may be formed.

The laminated capacitor 1 can be manufactured in the following manner, for example. Ceramic green sheets having a square shape formed with the pattern of the first electrode conductor layer 54 and ceramic green sheets with a square shape formed with the pattern of the second electrode conductor layer 57 are laminated alternately. A plurality of through holes 56 and 58 which pierce to a laminated direction are formed on predetermined position of the laminated body by laser or the like, and the through holes 56 and 58 are filled with conductive paste, so that the first type sub-core conductor 51a and the second type sub-core conductor 51b are formed. Thereafter, the laminated body which is formed with the first type sub-core conductor 51a and the second type sub-core conductor 51b is calcined. As a result, the laminated capacitor 1 where the corners of the outer peripheral surface 1a are approximately orthogonal shape is formed. Finally, the corners of the outer peripheral surface 1a of the laminated capacitor 1 are chipped off or cut so that the chamfered dimension becomes not less than 0.6 mm, so that the chamfered portions 1b (t) are formed. As a result, the laminated capacitor 1 which has the chamfered portions 1b (t) with chamfering dimension C1 of not less than 0.6 mm at the corners of the outer peripheral surface 1a can be formed.

A signal line for transmitting a signal to the semiconductor chip 2 is formed in the core main body 100m, but when a substance with high relative permittivity is present near the signal line, signal delay easily occurs. For this reason, when ceramic with high permittivity is used for the ceramic layer of the laminated capacitor 1, it is preferable that a distance from the signal line to the capacitor is large. In this embodiment, since the chamfered portions 1b (t) and the radius portions (round portions) 1c (r) are formed on the corners of the outer peripheral surface 1a of the laminated capacitor 1, the distance from the signal line which is present near the corners of the laminated capacitor 1 to the ceramic layer 52 becomes larger in comparison with a case where the chamfered portions 1b (t) and the radius portions 1c (r) are not formed. As a result, the signal delay of the signal line present near the corners of the laminated capacitor 1 can be reduced.

A direction and position recognition mark for recognizing a direction and a position of the laminated capacitor 1 with respect to the core board at the time of packaging of the laminated capacitor 1 is occasionally formed on the front or rear surface of the laminated capacitor 1. Since, however, a lot of terminals are present on the front and rear surfaces of the laminated capacitor 1, if the direction and position recognition mark is formed on their surfaces, the terminals are confused with the direction and position recognition mark, and thus misconception of the direction and position recognition mark possibly occurs. On the contrary, in the case where only one chamfered portion 1b (t) whose chamfering dimension C1 is different from the other plural chamfered portions 1b (t) is formed, the chamfered portion 1b (t) with different chamfering dimension C1 can be used as the direction and position recognition mark. As a result, even if the direction and position recognition mark is not formed on the front or rear surface of the laminated capacitor 1, the direction and the position of the laminated capacitor 1 with respect to the core main body 100m can be recognized. As a result, the misconception of the direction and position recognition mark can be solved.

In this embodiment, the linear coefficient of expansion of the ceramic layer 52 is smaller than the linear coefficient of expansion of the wiring board 200 mainly made of macromolecular material (concretely, the coefficient of thermal expansion of the core main body 100m) and larger than the linear coefficient of expansion of the semiconductor board of the semiconductor chip 2 to be mounted to the wiring board 200. For this reason, the difference in thermal expansion between the wiring board 200 and the semiconductor chip 2 can be mitigated, a crack of the semiconductor chip 2 due to thermal expansion of the wiring board 200 and the semiconductor chip 2 can be suppressed.

A second terminal array 7 is formed on the second main surface of the board core 100. The second terminal array 7 is composed of the second side first type terminal 7a and the second side second type terminal 7b which are conductive with the first side first type terminal 5a and the first side second type terminal 5b, respectively, and the second side signal terminal 7s which is conductive with the first side signal terminal 5s. The first terminal array 5 is formed in a positional relationship such that the entire array is included in a projection area of the sub-core portion 1 at the time of orthographic projection to the reference surface parallel with the plate surface of the board core 100 (for example, the first main surface of board core 100 can be used). A filling coupled portion 55 made of macromolecular material is formed in a space in the sub-core portion housing portion 100h as the gap between the sub-core portion 1 and the core man body 100m. The filling coupled portion 55 fixes the sub-core portion 1 to the core main body 100m, and absorbs the difference in the linear coefficient of expansion in the in-plane direction and the thicknesswise direction between the sub-core portion 1 and the core main body 100m by means of its elastic deformation.

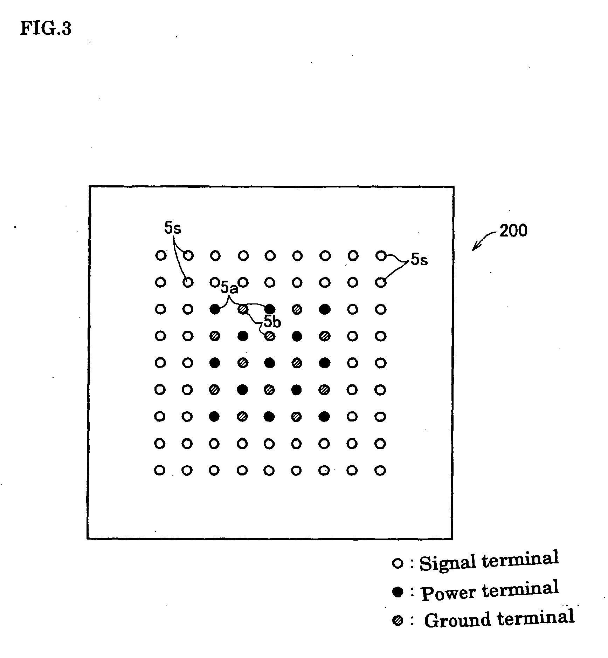

As shown in Fig. 3, in the first terminal array 5, the first side first type terminals 5a and the first side second type terminals 5b are arranged alternately in a reticular pattern (or houndtooth pattern). Similarly, in the second terminal array 7, the second side first type terminals 7a and the second side second type terminals 7b are arranged alternately in a reticular pattern (or houdtooth pattern) according to the terminal arrangement of the first terminal array 5. Both the arrays 5 and 7 have a plurality of first side signal terminals 5s and second side signal terminals 7s which surround the reticular arrangement of the power source terminals and the ground terminals.

In the board core 100 of Fig. 4, the first main surface of the sub-core portion 1 as well as the first main surface of the core main body 100m is covered with a first wiring laminated portion 61 where a dielectric layer 102 made of macromolecular material and conductor layers including wiring or a surface conductor for ground or power source are laminated alternately (so-called build-up wiring layer). The first terminal array 5 is exposed and formed from the first main surface of the first wiring laminated portion 61. With this constitution, since the sub-core portion 1 as well as the core main body 100m is collectively covered with the first wiring laminated portion 61, the first wiring laminated portion 61 and the first terminal array 5 can be formed by the approximately same steps as those of a general build-up organic package board, thereby contributing to simplification of the manufacturing steps.

The second main surface of the board core 100 is covered with a second wiring laminated portion 62 where the dielectric layer 102 made of macromolecular material and the conductor layer including wiring or the surface conductor for ground or power source are laminated alternately. The second terminal array 7 is exposed and formed from the first main surface of the second wiring laminated portion 62.

In both the wiring laminated portions 61 and 62, the dielectric layer 102 is formed into a thickness of, for example, not less than 20 µm to not more than 50 µm as a build-up resin insulating layer composed of resin composite such as epoxy resin. In this embodiment, the dielectric layer 102 is made of epoxy resin, and is obtained by mixing dielectric filler made of SiO₂ with the epoxy resin at a rate of not less than 10% by weight to not more than 30% by weight. Its relative permittivity ε is adjusted to 2 to 4 (for example, about 3). The conductor layer is formed into a thickness of about not less than 10 µm to not more than 20 µm where both the wiring and the surface conductor are pattern plated layers on the dielectric layer 102 (for example, an electrolytic Cu plated layer). The conductor layer has an area where the conductor is not arranged by patterning. The upper and lower dielectric layers occasionally contact with each other directly in the conductor unformed area.

In Fig. 4, the first type sub-core conductor 51a and the second type sub-core conductor 51b are formed in a thicknesswise direction of the sub-core portion 1. The first type sub-core conductor 51a and the second type sub-core conductor 51b correspond to the first side first type terminal 5a and the first side second type terminal 5b of the first terminal array 5, and are conductive with the second side first type terminal 7a and the second side second type terminal 7b of the second terminal array 7. The first type sub-core conductor 51a and the second type sub-core conductor 51b are conductive with the first side first type terminal 5a and the first side second type terminal 5b, respectively, via a via conductor 107 which is formed so as to pierce the dielectric layers 102 of the first wiring laminated portion 61. When the conductors 51a and 51b for ground and power source are formed in parallel in the sub-core portion 1, low inductance of paths for ground and power source and then low impedance can be realized. Both the first type sub-core conductor 51a and the second type sub-core conductor 51b are coupled with a second side first type surface conductor 211a and a second side second type surface conductor 211b in the second wiring laminated portion 62 via the via conductor 107. The second side first type terminal 7a and the second side second type terminal 7b of the second terminal array 7 are connected to the second side first type surface conductor 211a and the second side second type surface conductor 211b, respectively.

The via conductors 107 of the wiring laminated portions 61 and 62 have a structure such that via holes are drilled through the dielectric layer 102 by a publicly-known method such as photo via process (the dielectric layer 102 is composed of a photosensitive resin composition such as UV cure epoxy resin) or a laser boring via process (the dielectric layer 102 is composed of a non-photosensitive resin composition), and the insides of the via holes are filled or covered with a via conductor by plating or the like. Both the wiring laminated portions 61 and 62 are covered with a solder resist layer 101 composed of a photosensitive resin composition so that the terminal arrays 5 and 7 are exposed.

As shown in Fig. 3, in the first terminal array 5 (and the second terminal array 7), the first side first type terminal 5a and the first side second type terminal 5b are arranged in an array inside area, and the first side signal terminal 5s is arranged in the array outside area. As shown in Fig. 4, a wiring 108 for first side signal that draws out a signal transmission path to the outside of the arrangement area of the sub-core portion 1 is provided in the first wiring laminated portion 61 so as to be conductive with the first side signal terminal 5s. An end of the wiring 108 for first side signal is conductive with a through hole conductor 109s for signal formed in a thicknesswise direction of the core main body 100m so as to detour the sub-core portion 1.

In the element side terminal array 4 of the semiconductor integrated circuit element 2, the signal terminals 4s are arranged with a narrow gap similarly to the terminals 4a and 4b for power source and ground. As to the signal terminals 4s positioned on the outer peripheral portion of the array, its distance in-plane direction up to the corresponding second side signal terminal 7s in the second terminal array formed on the rear surface of the intermediate board 200 becomes large. In most cases, the terminal array 4 has to protrude to the outside of the sub-core portion 1. In the above constitution, however, the element side signal terminal 4s and the first side signal terminal 5s to be soldered and connected can be positioned just on the sub-core portion 1 whose effect for reducing the difference in linear coefficient expansion is remarkable, and the conductive state can be formed also for the second side signal terminal 7s which is sufficiently far without a problem.

The through hole conductor 109s formed on the core main body 100m has a larger axial section diameter than that of the via conductor 107 formed on the wiring laminated portions 61 and 62. Such a through hole conductor can be formed by drilling a through hole using a drill or the like through the core main body 100m in a plate thicknesswise direction, for example, and covering the inside of the through hole with a metal layer plated with Cu or the like. The inside of the through hole conductor 109s is filled with a resin hole filling material 109f such as epoxy resin. Further, both end surfaces of the through hole conductor 109s are sealed by conductor pads 110. In the case where the via conductor 107 and the conductor pad 110 are desired to be separated from the surface conductors for the power source layer and the ground layer in a DC manner, a hole portion 107i is formed on the surface conductor, and the via conductor 107 or the conductor pad 110 may be arranged in the hole portion 107i so that a circular gap is provided.

In the intermediate board 200 of Fig. 4, the sub-core housing portion 100h is constituted so as to pierce the core main body 100m, and the second wiring laminated portion 62 contacts with the second main surface of the sub-core portion 1 housed in the sub-core housing portion 100h. In this constitution, since the core main body 100m which is mainly made of the macromolecular material whose linear coefficient of expansion is large is eliminated from the position of the sub-core portion 1, the effect for reducing the difference in linear coefficient of expansion between the semiconductor integrated circuit element 2 and the intermediate board 200 can be remarkably achieved.

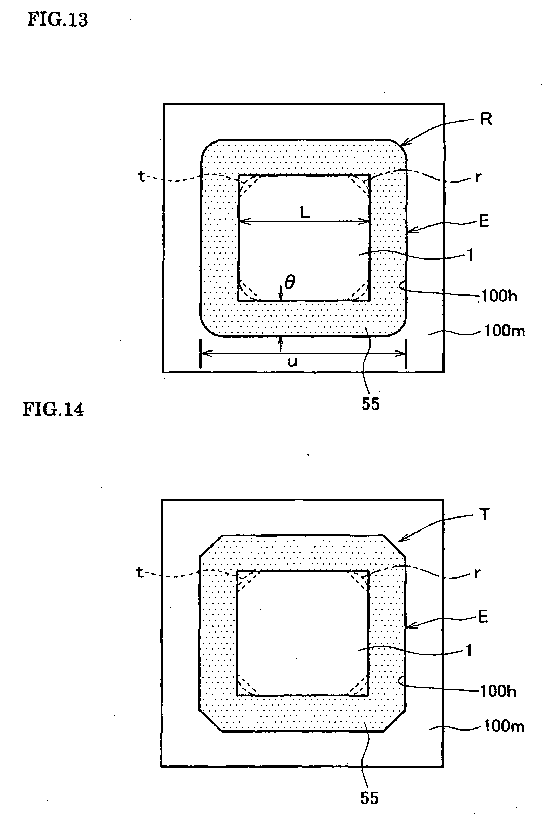

Fig. 13 typically illustrates a cross section of the sub-core housing portion 100h and the sub-core portion 1 taken along a plane (S-S) which is parallel with the plate surface of the sub-core portion 1 in the intermediate board 200 of Fig. 4. A gap between an inner peripheral surface of the sub-core housing portion 100h and the outer peripheral surface of the sub-core portion 1 is filled with the filling coupled portion 55. The sub-core housing portion 100h has a quadrate inner peripheral edge in the cross section, and a radius portion R with dimension of not less than 0.1 mm to not more than 2 mm is formed on its corners. A curved surface according to the radius surface of the sub-core housing portion 100h is formed also on protruded corners to be formed on the filling coupled portion 55 in accordance with the above corners. For this reason, air bubbles are hardly formed in the macromolecular material near the protruded corners, and concentricity of stress can be avoided even if temperature history is added. As a result, a crack or the like hardly occurs. Instead of the radius portions R, as shown in Fig. 14, a chamfered portion T in a similar dimension range may be formed. In Figs. 13 and 14, as to the inner edge of the sub-core housing portion 100h, sides other than the radius portion R or the chamfered portion T at the corners are formed linearly. When the radius portions R or the chamfered portions T of not less than 0.1 mm to not more than 2 mm are formed, the effect for preventing residual bubbles and crack is exerted. This effect is remarkably exerted in the case where when a dimension of one side of the sub-core portion 1 is L and a thickness of the filling coupled portion 55 (in a portion where the radius portions or the chamfered portions are not formed, a distance between the inner peripheral surface of the sub-core housing portion 100h and the outer peripheral surface of the sub-core portion 1 opposed to the inner surface) is θ, θ/L is adjusted to not less than 0.040 to not more than 0.090 (for example, θ= 0.8 mm, L = 12 mm, θ/L = 0.067). Further, from the similar viewpoint, an absolute value of the thickness θ may be set to not less than 0.50 mm to not more than 2.00 mm, desirably not less than 0.75 mm to not more than 1.50 mm, more desirably not less than 0.75 mm to not more than 1.25 mm.

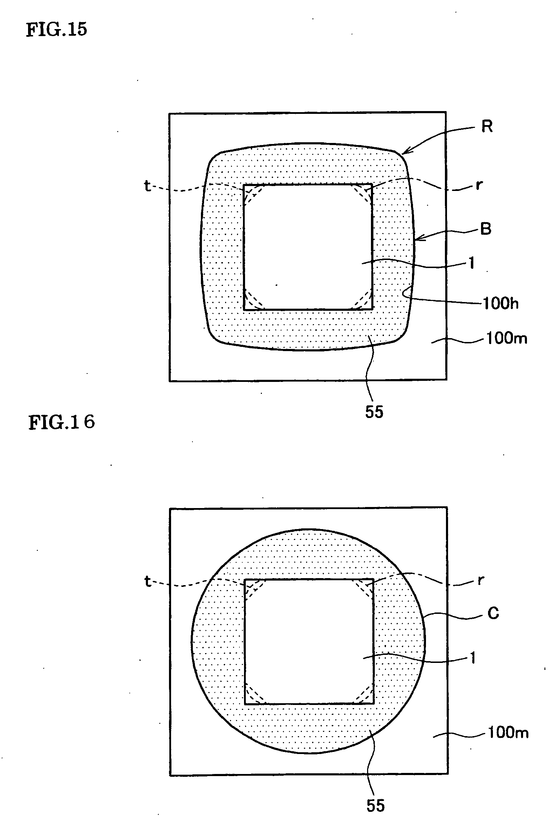

The inner edge of the sub-core housing portion 100h can be formed as shown in Fig. 15. That is to say, the radius portion R with dimension of not less than 0.1 mm to not more than 2 mm is formed on the corners, but the residual sides are curved portions B which are convex outward and whose curvature radius is larger than the radius portions. That is to say, in the sub-core housing portion 100h, the inner peripheral edge of the cross section along the plane parallel with the plate surface of the sub-core portion 1 is composed of only the curved portion with curvature radius of not less than 0.1 mm which is convex outward. Also with this constitution, the effect for suppressing residual bubbles and crack is produced similarly. As shown in Fig. 16, when the section inner peripheral edge C of the sub-core housing portion 100h is circular, the effect is further heightened.

A result of an experiment conducted in order to check the above effect is explained below. An experimental product of the intermediate board 200 in the constitution of Fig. 4 was manufactured so as to have the following constitution. The core main body 100m was a substrate where copper foil is applied to both surfaces of glass fiber-reinforced epoxy resin, and its thickness was set to 0.87 mm. The dimension L of one side of the sub-core housing portion 100h was variously set within a range of 13.5 mm to 15 mm. A size of the radius to be formed on the corners was set to 0.5 mm and 1.5 mm as two standards. On the other hand, the sub-core portion 1 was a calcined product of a laminated body where barium titanate with dimension of 12 mm x 12 mm and thickness of 0.87 mm and nickel electrodes were laminated alternately. Chamfered portions t with various dimensions of not less than 0.311 mm to not more than 1.174 mm were formed on the corners by chipping off using a cutting machine.

The above sub-core portion 1 was arranged in the sub-core housing portion 100h, and the gap therebetween was filled with epoxy resin as the filling coupled portion 55 and the epoxy resin was cured, so that a test product was produced. The thickness θ of the filling coupled portion 55 was set to various values in the range of not less than 0.75 mm to not more than 1.50 mm by adjusting the gap. These test products were subject to thermal impact test defined by U.S. MIL Standard 883D with 90 cycles under a defined condition C, so that a check was made whether a crack occurred at the corners of the sub-core housing portion 100h and the corners of the sub-core portion 1. The chamfering dimension of the sub-core portion 1 was classified into three standards: less than 0.1 mm, not less than 0.1 mm to less than 0.6 mm, and not less than 0.6 mm, and a number ratio of the test products where a crack occurred (the total number of the test products was 7 to 10 in the respective standards) was obtained. As a result, a test product where a crack occurred at the corner of the sub-core housing portion 100h was not recognized. On the other hand, as to the corners of the sub-core portion 1, the case where a crack was not found in all the test products was excellent ( ⊙), the case where even one test product where a crack occurred was found was satisfactory (○), the case where although a crack did not occur at the corners of the sub-core housing portion 100h, a crack occurred in all the corners of the sub-core portion 1 was passable (Δ). These results are shown in Tables 1 to 3.

**[Table 1]**

| L | θ | Inner surface R of sub-core housing portion | Chamfering of sub-core side C (mm) | Judgment | The number of passed judgment as to crack of sub-core side |
|---|---|---|---|---|---|
| 13.5mm | 0.75mm | 0.5mm | not less than 0.6 | ⊙ | 8/8 |
| | | | not less than 0.1 to less than 0.6 | ○ | 3/8 |
| | | | less than 0.1 | △ | 0/8 |
| | | 1.5mm | not less than 0.6 | ⊙ | 8/8 |
| | | | not less than 0.1 to less than 0.6 | ○ | 5/8 |
| | | | less than 0.1 | Δ | 0/8 |

**[Table 2]**

| L | θ | Inner surface R of sub-core housing portion | Chamfering of sub-core side C (mm) | Judgment | The number of passed judgment as to crack of sub-core side |
|---|---|---|---|---|---|
| 14.0mm | 1.00mm | 0.5mm | not less than 0.6 | ⊙ | 7/7 |
| | | | not less than 0.1 to less than 0.6 | ○ | 6/9 |
| | | | - | - | - |
| | | 1.5mm | not less than 0.6 | ⊙ | 9/9 |
| | | | not less than 0.1 to less than 0.6 | ○ | 5/7 |
| | | | - | - | - |

**[Table 3]**

| L | θ | Inner surface R of sub-core housing portion | Chamfering of sub-core side C (mm) | Judgment | The number of passed judgment as to crack of sub-core side |
|---|---|---|---|---|---|
| 15.0mm | 1.50mm | 0.5mm | not less than 0.6 | ⊙ | 9/9 |
| | | | not less than 0.1 to less than 0.6 | ○ | 6/7 |
| | | | - | - | - |
| | | 1.5mm | not less than 0.6 | ⊙ | 10/10 |
| | | | not less than 0.1 to less than 0.6 | ○ | 5/6 |
| | | | - | - | - |

According to the above results, when an amount of chamfering to be formed on the corners of the sub-core portion 1 is not less than 0.1 mm, particularly not less than 0.6 mm, a crack originated from the corners of the sub-core portion 1 can be suppressed effectively.

In all the constitutions of Figs. 13 to 16, the shape of the cross section along the plane parallel with the plate surface of the sub-core portion 1 is quadrate, and the corners have a pin corner shape, but as shown by alternate long and short dash lines in the drawings, a radius portion r with dimension of not less than 0.1 mm to not more than 2 mm can be formed on the corners of the sub-core portion 1. As a result, the concentricity of stress to the corners (protruded corners) of the filling coupled portion 55 can be reduced more easily. Further, the occurrence of crack in the filling coupled portion 55 originated from the corners of the sub-core portion 1 can be suppressed. As shown by broken lines in the drawings, instead of the radius portions r, a chamfered portion t in a similar dimensional range may be formed, and thus the similar effect can be achieved. The effect for suppressing the occurrence of crack originated from the corners of the sub-core portion 1 is exerted most greatly in the case where θ/L is adjusted to not less than 0.040 to not more than 0.090. From the similar viewpoint, the absolute value of the thickness θ may be set to not less than 0.75 mm to not more than 1.50 mm, desirably not less than 0.75 mm to not more than 1.25 mm.

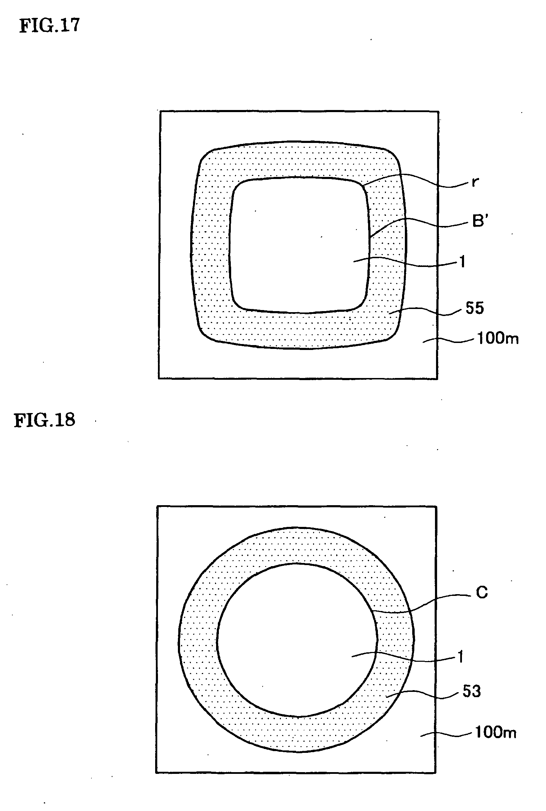

The outer edge of the sub-core portion 1 can be formed into a shape shown in Fig. 17. That is to say, the radius portion r with dimension of not less than 0.1 mm to not more than 2 mm is formed on the corners, but the other sides become curved portions B' which have larger curvature radius than the radius portion and are convex outward. That is to say, in the sub-core portion 1, the outer peripheral edge of the cross section along the plane parallel with the plate surface of the sub-core portion 1 is composed of only curved portion with curvature radius of not less than 0.1 mm which is convex outward. This constitution also provides the effect for suppressing residual bubbles and the occurrence of crack similarly. As shown in Fig. 18, when the inner peripheral edge C in the cross section of the sub-core portion 1 is circular, the effect is further heightened.

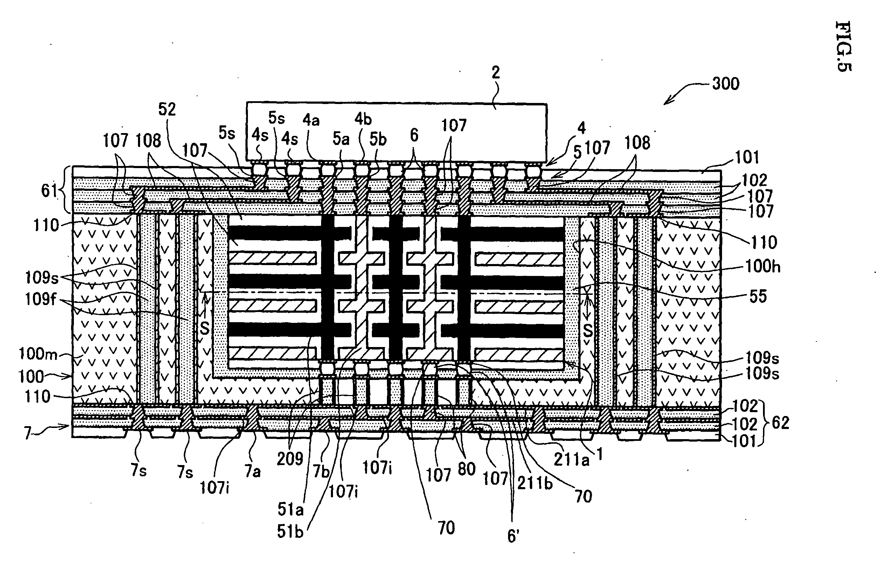

Various modified examples of the intermediate board according to the present invention are explained below. In the following constitution, portions constituted similarly to those in the intermediate board 200 of Fig. 4 are designated by similar numbers, and detailed explanation thereof is omitted. An intermediate board 300 in Fig. 5 is constituted so that the sub-core housing portion 100h is a concave portion with a bottom which opens for the first main surface of the core main body 100m. The second wiring laminated portion 62 is formed so as to contact with the second main surface of the core main body 100m on a rear surface of the concave portion. This structure has an advantage such that since the sub-core portion 1 is not exposed from the second main surface of the core main body 100m, the flat second wiring laminated portion 62 can be formed more simply. Concretely, a bottom through hole conductor portion 209, which is conductive with respective terminals composing the second terminal array 7, is formed so as to pierce a portion of the core main body 100m composing the bottom of the sub-core housing portion 100h. The sub-core conductors 51a and 51b formed on the sub-core portion 1 are conductive with the bottom through hole conductor portion 209. More specifically, a pad 80 of the bottom through hole conductor portion 209 is flip-chip connected to a pad 70 of the sub-core conductor via a soldering connection portion 6'. As the sectional shapes of the sub-core portion 1 and the sub-core housing portion 100h, similar ones explained with reference to Figs. 13 to 16 can be adopted.

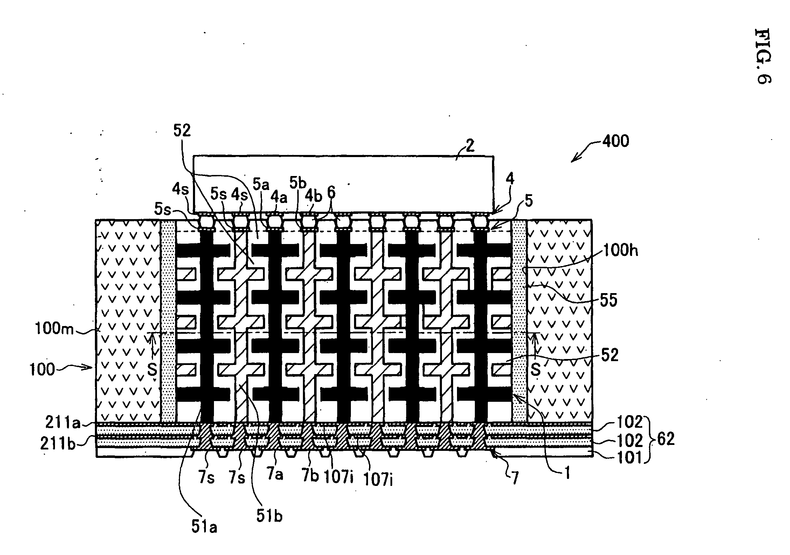

An intermediate board 400 in Fig. 6 is constituted so that the first side first type terminal 5a and the first side second type terminal 5b composing the first terminal array 5 is exposed and formed on the first main surface of the sub-core portion 1. The first type sub-core conductor 51a and the second type sub-core conductor 51b correspond to the first side first type terminal 5a and the first side second type terminal 5b of the first terminal array 5, and are conductive with the second side first type terminal 7a and the second side second type terminal 7b of the second terminal array 7. The first type sub-core conductor 51a and the second type sub-core conductor 51b are formed on the sub-core portion 1 in the thicknesswise direction. With this constitution, the first wiring laminated portion 61 mainly made of macromolecular material is eliminated from the first main surface of the sub-core portion 1, and the semiconductor integrated circuit element 2 and the sub-core portion 1 are directly connected by the soldering connection portion 6. As a result, the effect for reducing the difference in linear coefficient of expansion between the semiconductor integrated circuit element 2 and the intermediate board 400 is further improved. Since the wiring which is conductive with the terminals is not drawn around just on the sub-core portion 1, inductance of the transmission path conductive with the terminal can be reduced, thereby reducing the impedance. As the sectional shapes of the sub-core portion 1 and the sub-core housing portion 100h, similar ones explained with reference to Figs. 13 to 16 can be adopted.

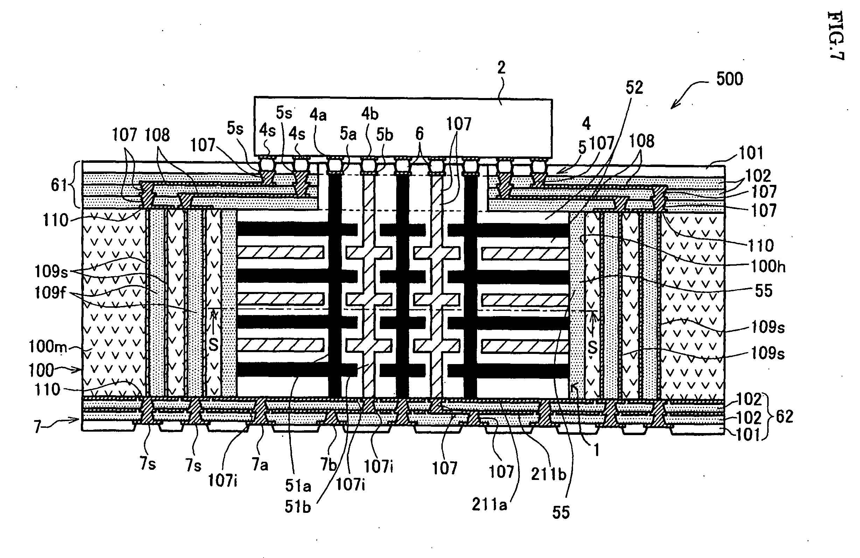

On the other hand, in an intermediate board (wiring board) 500 in Fig. 7, the outer peripheral edge of the first main surface of the sub-core portion 1 as well as the first main surface of the core main body 100m is covered with the first wiring laminated portion 61 where the dielectric layer 102 made of macromolecular material and the conductor layer including wiring or the surface conductor for ground or power source are laminated alternately. The first side signal terminal 5a is formed so as to be exposed from the surface of the first wiring laminated portion 61. First side signal wiring 108 where the signal transmission path is drawn out to the outside of the arrangement area of the sub-core portion 1 is provided in the first wiring laminated portion 61 so as to be conductive with the first side signal terminal 5s. An end of the first side signal wiring 108 is conductive with a signal through hole conductor 109s formed on the core main body 100m in the thicknesswise direction so as to detour the sub-core portion 1. Since this constitution enables the wiring conductive with the signal terminals on the array outer periphery to be greatly drawn out to an in-plane outer direction, this constitution is advantageous when the distance between the terminals in the first terminal array 5 is small. As the sectional shapes of the sub-core portion 1 and the sub-core housing portion 100h, similar ones explained with reference to Figs. 13 to 16 can be adopted.

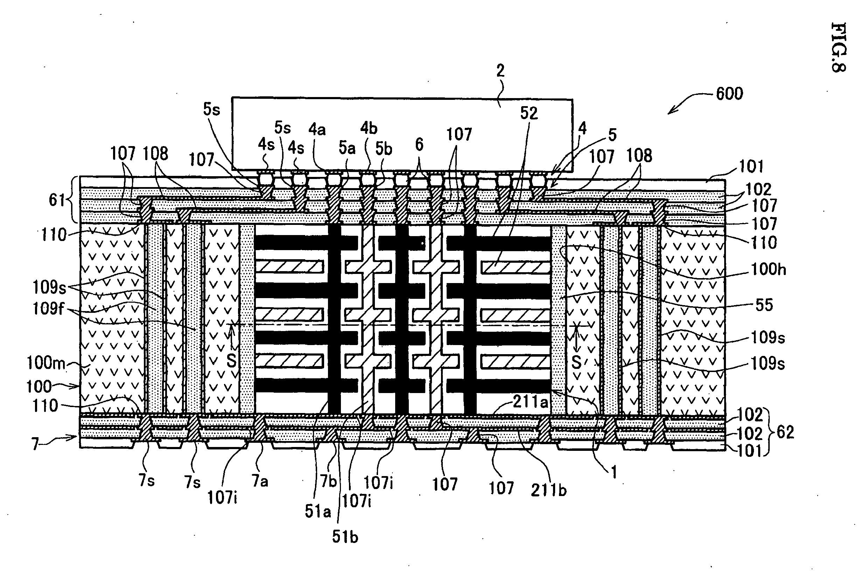

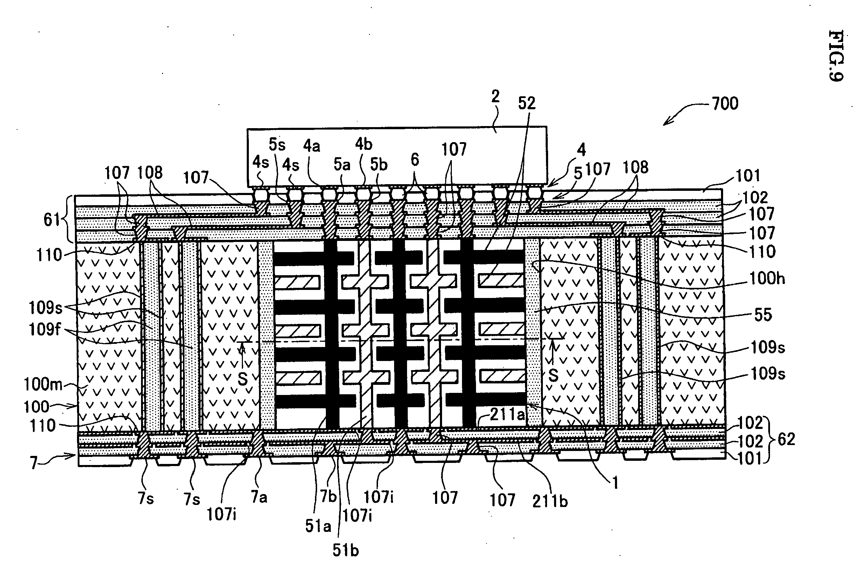

In the above embodiment, the sub-core portion 1 is formed so that its area is larger than that of the semiconductor integrated circuit element 2, but the sub-core portion 1 can be formed so as to have the approximately same area as the projection area of the semiconductor integrated circuit element 2. Like an intermediate board 600 of Fig. 8, the entire first terminal array 5 is set in the area of the sub-core portion 1, and simultaneously the sub-core portion 1 can be constituted into a smaller area than the semiconductor integrated circuit element 2. In the case where an influence upon the connected state between the terminals positioned on the outer periphery with respect to the semiconductor integrated circuit element 2 and the soldering connection portion 6 is not much concerned, like an intermediate board 700 of Fig. 9, it is not impossible that the area of the sub-core portion 1 is smaller than that of the area of the first terminal array 5. As the sectional shapes of the sub-core portion 1 and the sub-core housing portion 100h, similar ones explained with reference to Figs. 13 to 16 can be adopted.

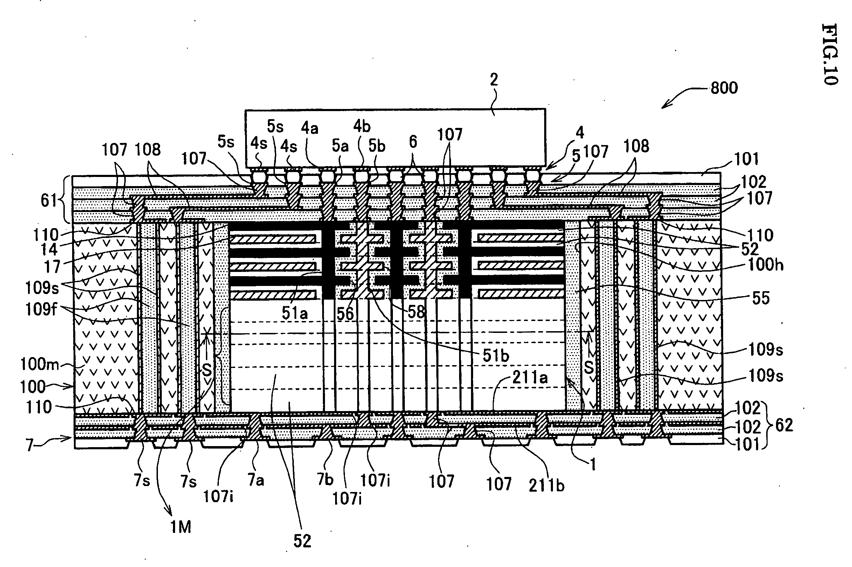

An intermediate board 800 in Fig. 10 is an example where only the ceramic layer 52 included in the sub-core portion 1 is used to form a capacitor, and the residual ceramic layer 52 is a sub-core main body 1M which does not include a capacitor. As the sectional shapes of the sub-core portion 1 and the sub-core housing portion 100h, similar ones explained with reference to Figs. 13 to 16 can be adopted.

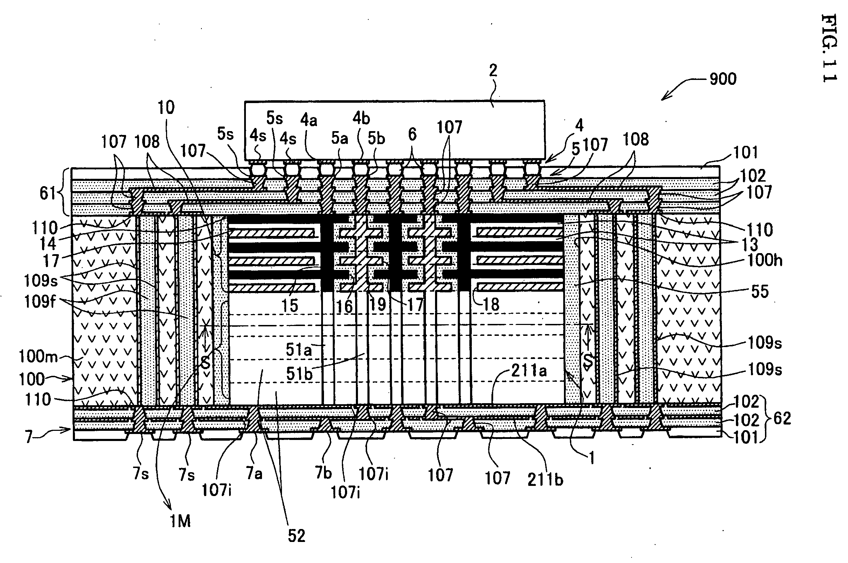

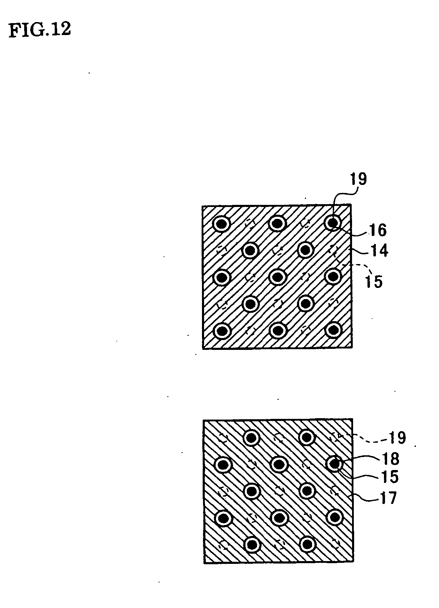

An intermediate board 900 in Fig. 11 is an example where the intermediate board 800 of Fig. 10 is developed, and the laminated capacitor is a thin-film capacitor portion 10 formed on the main surface of the sub-core portion 1. The thin-film capacitor portion 10 is constituted so that a plurality of dielectric thin films 13 (dielectric layer) and a plurality of electrode conductor thin films 14 and 17 (first electrode conductor layer 14 and the second electrode conductor layer 17) composing the capacitor are laminated alternately. The thin-film capacitor portion 10 is constituted so that the first electrode conductor layers 14 conductive with the first side first type terminal 5a and the second electrode conductor layers 17 conductive with the first side second type terminal 5b are arranged alternately in a laminated direction so as to be separated by the dielectric thin film 13. Since a total area is enlarged by multilayering of the electrode conductor thin films 14 and 17 and also the effect for thinning the dielectric layers is exerted, realizable electrostatic capacity can be greatly increased even if the element dimension is small. As the sectional shapes of the sub-core portion 1 and the sub-core housing portion 100h, similar ones explained with reference to Figs. 13 to 16 can be adopted. In Fig. 11, it seems that the electrode conductor thin films 14 and 17 are divided in an in-plane direction from the illustration of the through holes 16 and 18, but actually a continuous tin film is formed in the in-plane direction on the portions other than the through holes 16 and 18 as shown in Fig. 12. This is applied also to the dielectric thin film 13 (this constitution is applied also to the laminated capacitor 1 in Figs. 4 to 11).

A thickness of the dielectric thin film 13 is, for example, not less than 10 nm to not more than 1000 nm, more desirably not less than 30 nm to not more than 500 nm. On the other hand, thickness of the electrode conductor thin films 14 and 17 are, for example, not less than 10 nm to not more than 500 nm, more desirably not less than 50 nm to not more than 500 nm. The electrode conductor thin films 14 and 17 and the coupled conductor portions 15 and 19 (conductive with the first type sub-core conductor 51a and the second type sub-core conductor 51b of the sub-core portion 1 respectively) can be composed of metal such as Cu, Ag,' Au or Pt, and are formed by a vapor deposition method such as sputtering and vacuum deposition, and the vacuum deposition is used in this embodiment. On the other hand, the dielectric thin film 13 is composed of inorganic dielectric such as oxide or nitride, and is formed by the vapor deposition method such as high-frequency sputtering, reactive sputtering or chemical vapor deposition(CVD). In this embodiment, the dielectric thin film 13 is formed as an oxide thin film composed of compound oxide having a perovskite crystal structure selected from one or not less than two kinds of barium titanium, strontium titanate and lead titanate by a sol-gel method.

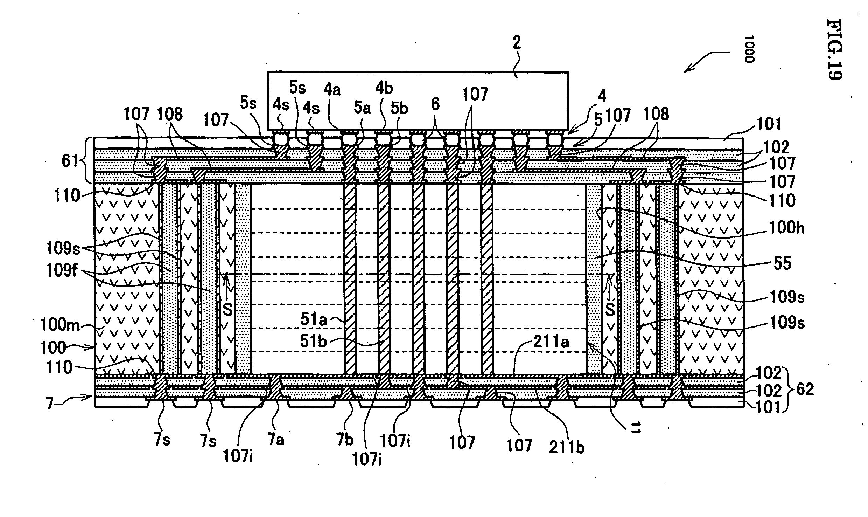

The intermediate board 1000 of Fig. 19 illustrates an example where a laminated capacitor of the sub-core portion 1 in the intermediate board 200 of Fig. 4 is a ceramic board 11. In the sub-core portion (ceramic board) 11, a publicly-known ceramic green sheet which contains material powder of the ceramic (glass ceramic is used in this embodiment) and via holes formed by punching, laser boring or the like and filled with metal powder paste are laminated and calcined. As a result, the sub-core conductors 51a and 51b are formed as a laminated via.

## Claims

1. A wiring board, comprising:
a board core (100) that is composed of a core main body (100m) formed into a plate shape by a macromolecular material and a sub-core portion (1), the core main body (100m) being formed with a sub-core housing portion (100h) which is opened and formed by reducing a thickness of the core main body (100m) on a first main body, the sub-core portion (1) being formed into a plate shape by a material with smaller linear coefficient of expansion than the core main body (100m) and being housed in the sub-core housing portion (100h) with its thicknesswise direction being matched with that of the core main body (100m);
a filling coupled portion (55) that is made of a macromolecular material which fills a gap between an inner peripheral surface of the sub-core housing portion (100h) and an outer peripheral surface of the sub-core portion (1);
a first terminal array (5) that is formed on the first main surface of the board core (100), and is composed of a first side first type terminal (5a) and a first side second type terminal (5b), one of which serves as a power source terminal and the other of which serves as a ground terminal, and a first side signal terminal (5S); and
a second terminal array (7) that is formed on a second main surface of the board core (100), and is composed of a second side first type terminal (7a) and a second side second type terminal (7b) which are conductive with the first side first type terminal (5a) and the second type terminal (5b), respectively, and a second side signal terminal (7s) which is conductive with the first side signal terminal (5s),
wherein the first terminal array (5) is formed in a position where it overlaps a projection area of the sub-core portion (1) in orthographic projection to a reference surface parallel with a plate surface of the board core (100),
**characterized in that** the sub-core housing portion (100h) has an inner peripheral edge of a cross section along the plane parallel with the plate surface of the sub-core portion (1) whose shape is quadrate, and a radius portion (R) or a chamfered portion (T) with dimension of not less than 0.1 mm to not more than 2 mm is formed on its corners,
wherein the sub-core portion (1) has an outer peripheral edge of the cross section along the plane parallel with the plate surface of the sub-core portion (1) formed into a quadrate shape, and a radius portion (1c(r)) or a chamfered portion (1c(t)) with dimension of not less than 0.1 mm to not more than 2 mm is formed on its corners, or
wherein the sub-core portion (1) has an outer peripheral edge of the cross section along the plane parallel with the plate surface of the sub-core portion (1) composed of only a curved portion (B') with curvature radius of not less than 0.1 mm which is convex outward.

2. A wiring board, comprising:
a board core (100) that is composed of a core main body (100m) formed into a plate shape by a macromolecular material and a sub-core portion (1), the core main body (100m) being formed with a sub-core housing portion (100h) which is opened and formed by reducing a thickness of the core main body (100m) on a first main body, the sub-core portion (1) being formed into a plate shape by a material with smaller linear coefficient of expansion than the core main body (100m) and being housed in the sub-core housing portion (100h) with its thicknesswise direction being matched with that of the core main body (100m);
a filling coupled portion (55) that is made of a macromolecular material which fills a gap between an inner peripheral surface of the sub-core housing portion (100h) and an outer peripheral surface of the sub-core portion (1);
a first terminal array (5) that is formed on the first main surface of the board core (100), and is composed of a first side first type terminal (5a) and a first side second type terminal (5b), one of which serves as a power source terminal and the other of which serves as a ground terminal, and a first side signal terminal (5s); and
a second terminal array (7) that is formed on a second main surface of the board core (100), and is composed of a second side first type terminal (7a) and a second side second type terminal (7b) which are conductive with the first side first type terminal (5a) and the second type terminal (5b), respectively, and a second side signal terminal (7s) which is conductive with the first side signal terminal (5s),
wherein the first terminal array (5) is formed in a position where it overlaps a projection area of the sub-core portion (1) in orthographic projection to a reference surface parallel with a plate surface of the board core (100),
**characterized in that** the sub-core housing portion (100h) has an inner peripheral edge of a cross section along the plane parallel with a plate surface of the sub-core portion (1) which is composed of only a curved portion (B) with curvature radius of not less than 0.1 mm which is convex outward,
wherein the sub-core portion (1) has an outer peripheral edge of the cross section along the plane parallel with the plate surface of the sub-core portion (1) formed into a quadrate shape, and a radius portion (1c(r)) or a chamfered portion (1c(t)) with dimension of not less than 0.1 mm to not more than 2 mm is formed on its corners, or
wherein the sub-core portion (1) has an outer peripheral edge of the cross section along the plane parallel with the plate surface of the sub-core portion (1) composed of only a curved portion (B') with curvature radius of not less than 0.1 mm which is convex outward.

3. The wiring board according to claim 1 or 2, wherein the sub-core portion (1) incorporates a laminated capacitor (2) where a first electrode conductor layer (51a) which is conductive with the first side first type terminal (5a) and the second side first type terminal (7a), a dielectric layer (13), and a second electrode conductor layer (51b) which is conductive with the first side second type terminal (5b) and the second side second type terminal (7b) are laminated in this order.

4. The wiring board according to claim 2, wherein the sub-core housing portion (100h) has an inner peripheral edge of the cross section formed into a circular shape (C).

5. The wiring board according to any of the claims 1 to 4, wherein the outer peripheral edge of the cross section of the sub-core portion (1) is formed into a circular shape (C').

6. The wiring board according to any one of claims 1 to 5, wherein the first terminal array (5) is formed in the position where it is entirely included in the projection area of the sub-core portion (1) in orthographic projection to the reference surface parallel with the plate surface of the board core (100).

7. The wiring board according to any one of claims 1 to 6, wherein the board core (100) is constituted so that the first main surface of the sub-core portion (1) as well as the first main surface of the core main body (100m) is covered with a first wiring laminated portion (61) where a dielectric layer (102) made of a macromolecular material and a conductor layer (108) including wiring or a surface conductor for ground or power source are laminated, and the first terminal array (5) is exposed from the first main surface of the first wiring laminated portion (61).

8. The wiring board according to claim 7, wherein a first type sub-core conductor (51a) and a second type sub-core conductor (51b), which correspond to the first side first type terminal (5a) and the first side second type terminal (5b) of the first terminal array (5), respectively and are conductive with the second side first type terminal (7a) and the second side second type terminal (7b) of the second terminal array (7), respectively, are formed in a thicknesswise direction of the sub-core portion (1), and the first type sub-core conductor (51a) and the second type sub-core conductor (51b) are conductive with the first side first type terminal (5a) and the first side second type terminal (5b), respectively, via a via conductor (107) formed so as to pierce the dielectric layers (102) of the first wiring laminated portion (61).

9. The wiring board according to claim 7 or 8, wherein
in the first terminal array (5), the first side first type terminal (5a) and the first side second type terminal (5b) are arranged in an array inside area, and the first side signal terminal (5s) is arranged in an array outside area,
first side signal wiring (108) for drawing out a signal transmission path to the outside of an arrangement area of the sub-core portion (1) is provided in the first wiring laminated portion (61) so as to be conductive with the first side signal terminal (5s), and an end of the first side signal wiring (1) is conductive with a signal through hole conductor (109s) formed in a thicknesswise direction of the core main body (100m) so as to detour the sub-core portion (1).

10. The wiring board according to any one of claims 1 to 6, wherein the first side first type terminal (5a) and the first side second type terminal (5b) composing the first terminal array (5) are exposed to be formed on the first main surface of the sub-core portion (1), and the first type sub-core conductor (51a) and the second type sub-core conductor (51b), which correspond to the first side first type terminal (5a) and the first side second type terminal (5b) of the first terminal array (5) and are conductive with the second side first type terminal (7a) and the second side second type terminal (7b) of the second terminal array (7), are formed in the thicknesswise direction of the sub-core portion (1).

11. The wiring board according to claim 10, wherein
the outer peripheral edge of the first main surface of the sub-core portion (1) as well as the first main surface of the core main body (100m) is covered with a first wiring laminated portion (61) where a dielectric layer (102) made of a macromolecular material and a conductor layer including wiring or a surface conductor for ground or power source are laminated, and the first side signal terminal (5s) is exposed to be formed on the surface of the first wiring laminated portion (61),
the first side signal wiring (108) that draws out the signal transmission path to the outside of the arrangement area of the sub-core portion (1) is provided in the first wiring laminated portion (61) so as to be conductive with the first side signal terminal (5s), and the end of the first side signal wiring (108) is conductive with a signal through hole conductor (109s) formed in the thicknesswise direction of the core main body (100m) so as to detour the sub-core portion (1).

12. The wiring board according to any one of claims 1 to 11, wherein the sub-core portion (1) is formed so as to have an area which is equivalent to or larger than that of the formation area of the first terminal array (5).

13. The wiring board according to any one of claims 1 to 12, wherein the insulating portion of the sub-core portion (1) is mainly made of ceramic.

14. The wiring board according to claim 13, wherein the ceramic is alumina or glass ceramic.

15. The wiring board according to any one of claims 1 to 14, wherein the sub-core portion (1) is composed of a calcined laminated ceramic capacitor.

16. The wiring board according to claim 3, wherein the laminated capacitor (2) is composed of a thin-film capacitor formed on the main surface of the sub-core portion (1).

## Patentansprüche

1. Ein Verdrahtungsträger, umfassend:
einen Träger-Kern (100), der zusammengesetzt ist aus einem Kern-Haupt-Körper (100m) geformt in eine Platten-Gestalt durch ein makromolekulares Material und einem Sub-Kern-Bereich (1), wobei der Kern-Haupt-Körper (100m) mit einem Sub-Kern-Gehäuse-Bereich (100h) geformt ist, der geöffnet und durch Reduzieren einer Dicke des Kern-Haupt-Körpers (100m) auf einem ersten Haupt-Körper geformt ist, wobei der Sub-Kern-Bereich (1) in Platten-Gestalt geformt ist durch ein Material mit geringerem linearen Ausdehnungskoeffizienten als der Kern-Haupt-Körper (100m) und gehäust ist im Sub-Kern-Gehäuse-Bereich (100h), wobei seine Dickenrichtung abgeglichen ist mit der des Kern-Haupt-Körpers (100m);
einen Füllungskoppelbereich (55), der aus einem makromolekularen Material hergestellt ist, das einen Spalt zwischen einer inneren peripheren Oberfläche des Sub-Kem-Gehäuse-Bereichs (100h) und einer äußeren peripheren Oberfläche des Sub-Kern-Bereichs (1) füllt;
ein erstes Anschlussfeld (5), das geformt ist auf der ersten Haupt-Oberfläche des Träger-Kerns (100) und zusammengesetzt aus einem Anschluss ersten Typs der ersten Seite (5a) und einem Anschluss zweiten Typs der ersten Seite (5b), einer davon dient als ein Stromversorgungs-Anschluss und der andere davon als ein Masse-Anschluss, und ein Signal-Anschluss der ersten Seite (5s); und
ein zweites Anschlussfeld (7), das geformt ist auf einer zweiten Hauptoberfläche des Träger-Kerns (100), und zusammengesetzt aus einem Anschluss ersten Typs der zweiten Seite (7a) und einem Anschluss zweiten Typs der zweiten Seite (7b), welche leitend sind mit dem Anschluss ersten Typs der ersten Seite (5a), beziehungsweise mit dem Anschluss zweiten Typs (5b), und ein Signal-Anschluss der zweiten Seite (7s), der leitend ist mit dem Signal-Anschluss der ersten Seite (5s),
wobei das erste Anschlussfeld (5) in einer Position geformt ist, wo es eine Projektionsfläche des Sub-Kern-Bereichs (1) in orthographischer Projektion zu einer Bezugs-Oberfläche parallel mit einer Platten-Oberfläche des Träger-Kerns (100) überlappt,
**gekennzeichnet dadurch, dass** der Sub-Kern-Gehäuse-Bereich (100h) eine innere periphere Kante eines Querschnitts entlang der Ebene parallel mit der Platten-Oberfläche des Sub-Kern-Bereichs (1) hat, deren Gestalt ein Quadrat ist, und ein Radius-Bereich (R) oder ein abgeschrägter Bereich (T) mit einer Größenordnung von nicht weniger als 0,1 mm bis nicht mehr als 2 mm an seinen Ecken geformt ist,
wobei der Sub-Kern-Bereich (1) eine äußere periphere Kante des Querschnitts entlang der Ebene parallel mit der Platten-Oberfläche des zu einer Quadrat-Gestalt geformten Sub-Kern-Bereichs (1) hat, und ein Radius-Bereich (1c(r)) oder ein abgeschrägter Bereich (1c(t)) mit Dimension von nicht weniger als 0,1 mm bis nicht mehr als 2 mm an seinen Ecken geformt ist, oder
wobei der Sub-Kern-Bereich (1) eine äußere periphere Kante des Querschnitts entlang der Ebene parallel mit der Platten-Oberfläche des Sub-Kern-Bereichs (1) hat, die zusammengesetzt ist aus nur einem gekrümmten Bereich (B') mit einem Krümmungsradius von nicht weniger als 0,1 mm der konvex nach außen ist.

2. Ein Verdrahtungsträger, umfassend:
einen Träger-Kern (100), der zusammengesetzt ist aus einem Kern-Haupt-Körper (100m) geformt in eine Platten-Gestalt durch ein makromolekulares Material und einem Sub-Kern-Bereich (1), wobei der Kern-Haupt-Körper (100m) mit einem Sub-Kern-Gehäuse-Bereich (100h) geformt ist, der geöffnet und durch Reduzieren einer Dicke des Kern-Haupt-Körpers (100m) auf einem ersten Haupt-Körper geformt ist, wobei der Sub-Kern-Bereich (1) in Platten-Gestalt geformt ist durch ein Material mit geringerem linearen Ausdehnungskoeffizienten als der Kern-Haupt-Körper (100m) und gehäust ist im Sub-Kern-Gehäuse-Bereich (100h), wobei seine Dickenrichtung abgeglichen ist mit der des Kern-Haupt-Körpers (100m);
einen Füllungskoppelbereich (55), der aus einem makromolekularen Material hergestellt ist, das einen Spalt zwischen einer inneren peripheren Oberfläche des Sub-Kem-Gehäuse-Bereichs (100h) und einer äußeren peripheren Oberfläche des Sub-Kern-Bereichs (1) füllt;
ein erstes Anschlussfeld (5), das geformt ist auf der ersten Haupt-Oberfläche des Träger-Kerns (100) und zusammengesetzt ist aus einem Anschluss ersten Typs der ersten Seite (5a) und einem Anschluss zweiten Typs der ersten Seite (5b), einer davon dient als ein Stromversorgungs-Anschluss und der andere davon dient als ein Masse-Anschluss, und ein Signal- Anschluss der ersten Seite (5s); und
ein zweites Anschlussfeld (7), das geformt ist auf einer zweiten Hauptoberfläche des Träger-Kerns (100) und zusammengesetzt ist aus einem Anschluss ersten Typs der zweiten Seite (7a) und einem Anschluss zweiten Typs der zweiten Seite (7b), welche leitend sind mit dem Anschluss ersten Typs der ersten Seite (5a) beziehungsweise mit dem Anschluss zweiten Typs (5b), und ein Signal-Anschluss der zweiten Seite (7s), der leitend ist mit dem Signal-Anschluss der ersten Seite (5s), wobei
das erste Anschlussfeld (5) in einer Position geformt ist, wo es eine Projektionsfläche des Sub-Kern-Bereichs (1) in orthographischer Projektion zu einer Bezugs-Oberfläche parallel mit einer Platten-Oberfläche des Träger-Kerns (100) überlappt,
**gekennzeichnet dadurch, dass** der Sub-Kern-Gehäuse-Bereich (100h) eine innere periphere Kante eines Querschnitts entlang der Ebene parallel mit einer Platten-Oberfläche des Sub-Kern-Bereichs (1) hat, die zusammengesetzt ist aus nur einem gekrümmten Bereich (B) mit einem Krümmungsradius von nicht weniger als 0,1 mm, der nach außen konvex ist,
wobei der Sub-Kern-Bereich (1) eine äußere periphere Kante des Querschnitts entlang der Ebene parallel mit der Platten-Oberfläche des zu einer Quadrat-Gestalt geformten Sub-Kern-Bereichs (1) hat, und einen Radius-Bereich (1c(r)) oder einen abgeschrägten Bereich (1c(t)) mit Dimension von nicht weniger als 0,1 mm bis nicht mehr als 2 mm an seinen Ecken geformt hat, oder
wobei der Sub-Kern-Bereich (1) eine äußere periphere Kante des Querschnitts entlang der Ebene parallel mit der Platten-Oberfläche des Sub-Kern-Bereichs (1) hat, der nur zusammengesetzt ist aus einem gekrümmten Bereich (B') mit einem Krümmungsradius von nicht weniger als 0, 1 mm, der konvex nach außen ist.

3. Der Verdrahtungsträger gemäß Anspruch 1 oder 2, wobei
der Sub-Kern-Bereich (1) einen laminierten Kondensator (2) aufnimmt, wo eine erste Elektroden-Leiter-Schicht (51a), die leitend ist mit dem Anschluss ersten Typs der ersten Seite (5a) und dem ersten Anschluss ersten Typs der zweiten Seite (7a), eine dielektrische Schicht (13), und eine zweite Elektroden-Leiter-Schicht (51b), die leitend ist mit dem Anschluss zweiten Typs der ersten Seite (5b) und dem Anschluss zweiten Typs der zweiten Seite (7b), in dieser Reihenfolge laminiert sind.

4. Der Verdrahtungsträger gemäß Anspruch 2, wobei
der Sub-Kern-Gehäuse-Bereich (100h) eine innere periphere Kante des zu einer zirkulären Gestalt (C) geformten Querschnitts hat.

5. Der Verdrahtungsträger gemäß einem der Ansprüche 1 bis 4, wobei
die äußere periphere Kante des Querschnitts des Sub-Kern-Bereichs (1) zu einer zirkulären Gestalt (C') geformt ist.

6. Der Verdrahtungsträger gemäß einem der Ansprüche 1 bis 5, wobei
das erste Anschlussfeld (5) in der Position geformt ist, wo es vollständig einbezogen ist in die Projektionsfläche des Sub-Kern-Bereichs (1) in orthographischer Projektion zur Bezugs-Oberfläche parallel mit der Platten-Oberfläche des Träger-Kerns (100).

7. Der Verdrahtungsträger gemäß einem der Ansprüche 1 bis 6, wobei
der Träger-Kern (100) so zusammengesetzt ist, dass die erste Haupt-Oberfläche des Sub-Kern-Bereichs (1), wie auch die erste Haupt-Oberfläche des Kern-Haupt-Körpers (100m), bedeckt ist mit einem ersten verdrahtungslaminierten Bereich (61), wo eine dielektrische Schicht (102) die aus einem makromolekularem Material hergestellt ist, und eine Leiter-Schicht (108) umfassend Verdrahtung oder einen Oberflächen-Leiter für Masse oder Stromversorgung laminiert sind, und das erste Anschlussfeld (5) entblößt ist von der ersten Haupt-Oberfläche des ersten laminierten Verdrahtungs-Bereichs (61).

8. Der Verdrahtungsträger gemäß Anspruch 7, wobei
ein Sub-Kern-Leiter ersten Typs (51 a) und ein Sub-Kern-Leiter zweiten Typs (51b), welche zum Anschluss ersten Typs der ersten Seite (5a) beziehungsweise dem Anschluss zweiten Typs der ersten Seite (5b) des ersten Anschlussfelds (5) korrespondieren, und leitend sind mit dem Anschluss ersten Typs der zweiten Seite (7a) beziehungsweise dem Anschluss zweiten Typs der zweiten Seite (7b) des zweiten Anschluss-Felds (7), in einer Dickenrichtung des Sub-Kern-Bereichs (1) geformt sind, und der Sub-Kern-Leiter ersten Typs (51a) und der Sub-Kern-Leiter zweiten Typs (51b) leitend sind mit dem Anschluss ersten Typs der ersten Seite (5a) beziehungsweise dem Anschluss zweiten Typs der ersten Seite (5b) über einen Durchgangsleiter (107), der geformt ist, die dielektrischen Schichten (102) des ersten verdrahtungslaminierten Bereichs (61) zu durchstechen.

9. Der Verdrahtungsträger gemäß Anspruch 7 oder 8, wobei
im ersten Anschlussfeld (5) der Anschluss ersten Typs der ersten Seite (5a) und der Anschluss zweiten Typs der ersten Seite (5b) in einer Anschlussfeld-Innenfläche angeordnet sind, und der Signal-Anschluss der ersten Seite (5s) in einer Anschlussfeld-Außenfläche angeordnet ist,
die Signalverdrahtung der ersten Seite (108) zum Herausziehen eines Signalübertragungspfades zur Außenseite eines Anordnungsbereichs des Sub-Kern-Bereichs (1) im ersten verdrahtungslaminierten Bereich (61) bereitgestellt ist, um leitend mit dem Signalanschluss der ersten Seite (5s) zu sein, und ein Ende der Signal-Verdrahtung der ersten Seite (1) ist leitend mit einem Signal Durchgangsloch-Leiter (109s), der in einer Dickenrichtung des Kern-Haupt-Körpers (100m) geformt ist, um den Sub-Kern-Bereich (1) zu umgehen.

10. Der Verdrahtungsträger gemäß einem der Ansprüche 1 bis 6, wobei
der Anschluss ersten Typs der ersten Seite (5a) und der Anschluss zweiten Typs der ersten Seite (5b), die das erste Anschlussfeld (5) bilden, entblößt sind, um auf der ersten Haupt-Oberfläche des Sub-Kern-Bereichs (1) geformt zu sein, und der Sub-Kern-Leiter ersten Typs (51a) und der Sub-Kern-Leiter zweiten Typs (51b), welche dem Anschluss ersten Typs der ersten Seite (5a) und dem Anschluss zweiten Typs der ersten Seite (5b) des ersten Anschlussfelds (5) entsprechen und leitend sind mit dem Anschluss ersten Typs der zweiten Seite (7a) und dem Anschluss zweiten Typs der zweiten Seite (7b) des zweiten Anschlussfelds (7), in einer Dickenrichtung des Sub-Kern-Bereichs (1) geformt sind.

11. Der Verdrahtungsträger gemäß Anspruch 10, wobei
die äußere periphere Kante der ersten Haupt-Oberfläche des Sub-Kern-Bereichs (1), wie auch die erste Haupt-Oberfläche des Kern-Haupt-Körpers (100m), bedeckt ist mit einem ersten verdrahtungslaminierten Bereich (61), wo eine dielektrische Schicht (102), die aus einem makromolekularen Material hergestellt ist, und eine Leiter-Schicht umfassend Verdrahtung oder einen Oberflächenleiter für Masse oder Stromversorgung laminiert sind, und der Signal-Anschluss der ersten Seite (5s) entblößt ist, um auf der Oberfläche des ersten verdrahtungslaminierten Bereichs (61) geformt zu sein,
die Signalverdrahtung der ersten Seite (108), die den Signal-Übertragungs-Pfad zur Außenseite des Anordnungsbereichs des Sub-Kern-Bereichs (1) herausführt, im ersten verdrahtungslaminierten Bereich (61) bereitgestellt ist, um leitend mit dem Signal-Anschluss der ersten Seite (5s) zu sein, und das Ende der Signalverdrahtung der ersten Seite (108) ist leitend mit einem Signal-Durchgangsloch-Leiter (109s), der in Dickenrichtung des Kern-Haupt-Körpers (100m) geformt ist, um den Sub-Kern-Bereich (1) zu umgehen.

12. Der Verdrahtungsträger gemäß einem der Ansprüche 1 bis 11, wobei
der Sub-Kern-Bereich (1) geformt ist, um eine Fläche zu haben, die gleichwertig zu oder größer als jene des Bildungsbereiches des ersten Anschlussfelds (5) ist.

13. Der Verdrahtungsträger gemäß einem der Ansprüche 1 bis 12, wobei
der Isolations-Bereich des Sub-Kern-Bereichs (1) hauptsächlich aus Keramik hergestellt ist.

14. Der Verdrahtungsträger gemäß Anspruch 13, wobei
die Keramik Alumniumoxid oder Glaskeramik ist.

15. Der Verdrahtungsträger gemäß einem der Ansprüche 1 bis 14, wobei
der Sub-Kern-Bereich (1) zusammengesetzt ist aus einem gebrannten laminierten keramischen Kondensator.

16. Der Verdrahtungsträger gemäß Anspruch 3, wobei
der laminierte Kondensator (2) zusammengesetzt ist aus einem auf der Hauptoberfläche des Sub-Kern-Bereichs (1) geformten Dünnfilm-Kondensator.

## Revendications

1. Carte de câblage, comprenant :
un noyau de carte (100) qui se compose d'un corps principal de noyau (100m) façonné selon une forme de plaque par un matériau macromoléculaire et d'une partie sous-noyau (1), le corps principal de noyau (100m) étant pourvu d'une partie logement de sous-noyau (100h) qui est ouverte et formée en réduisant une épaisseur du corps principal de noyau (100m) sur un premier corps principal, la partie sous-noyau (1) étant façonnée selon une forme de plaque par un matériau ayant un coefficient de dilatation linéaire inférieure à celui du corps principal de noyau (100m) et logée dans la partie logement de sous-noyau (100h), sa direction dans le sens de l'épaisseur correspondant à celui du corps principal de noyau (100m) ;
une partie de remplissage accouplée (55) qui se compose d'un matériau macromoléculaire qui remplit un espace situé entre une surface périphérique intérieure de la partie logement de sous-noyau (100h) et une surface périphérique extérieure de la partie sous-noyau (1) ;
un premier réseau de bornes (5) qui est formé sur la première surface principale du noyau de carte (100), et se compose d'une borne de premier type de premier côté (5a) et d'une borne de second type de premier côté (5b), l'une d'elles servant de borne d'alimentation et l'autre servant de borne de terre, et d'une borne de signal de premier côté (5s) ; et
un second réseau de bornes (7) qui est formé sur une seconde surface principale du noyau de carte (100), et se compose d'une borne de premier type de second côté (7a) et d'une borne de second type de second côté (7b) qui sont respectivement conductrices avec la borne de premier type (5a) et la borne de second type (5b) de premier côté, et d'une borne de signal de second côté (7s) qui est conductrice avec la borne de signal de premier côté (5s),
dans lequel le premier réseau de bornes (5) est formé dans une position où il chevauche une zone de projection de la partie sous-noyau (1) dans une projection orthographique par rapport à une surface de référence parallèle à une surface de plaque du noyau de carte (100),
**caractérisée en ce que** la partie logement de sous-noyau (100h) a un bord périphérique intérieur d'une coupe transversale le long du plan parallèle à la surface de plaque de la partie sous-noyau (1) dont la forme est carrée, et une partie rayon (R) ou une partie chanfreinée (T) d'une dimension ne faisant pas moins de 0,1 mm mais ne dépassant pas 2 mm est formée sur ses coins,
dans laquelle la partie sous-noyau (1) a un bord périphérique extérieur de la coupe transversale le long du plan parallèle à la surface de plaque de la partie sous-noyau (1) de forme carrée, et une partie rayon (1c(r)) ou une partie chanfreinée (1c(t)) d'une dimension ne faisant pas moins de 0,1 mm mais ne dépassant pas 2 mm est formée sur ses coins, ou
dans laquelle la partie sous-noyau (1) a un bord périphérique extérieur de la coupe transversale le long du plan parallèle à la surface de plaque de la partie sous-noyau (1) se composant uniquement d'une partie incurvée (B') ayant un rayon de courbure ne faisant pas moins de 0,1 mm qui est convexe vers l'extérieur.

2. Carte de câblage, comprenant :
un noyau de carte (100) qui se compose d'un corps principal de noyau (100m) façonné selon une forme de plaque par un matériau macromoléculaire et d'une partie sous-noyau (1), le corps principal de noyau (100m) étant pourvu d'une partie logement de sous-noyau (100h) qui est ouverte et formée en réduisant une épaisseur du corps principal de noyau (100m) sur un premier corps principal, la partie sous-noyau (1) étant façonnée selon une forme de plaque par un matériau ayant un coefficient de dilatation linéaire inférieure à celui du corps principal de noyau (100m) et logée dans la partie logement de sous-noyau (100h), sa direction dans le sens de l'épaisseur correspondant à celui du corps principal de noyau (100m) ;
une partie de remplissage accouplée (55) qui se compose d'un matériau macromoléculaire qui remplit un espace situé entre une surface périphérique intérieure de la partie logement de sous-noyau (100h) et une surface périphérique extérieure de la partie sous-noyau (1) ;
un premier réseau de bornes (5) qui est formé sur la première surface principale du noyau de carte (100), et se compose d'une borne de premier type de premier côté (5a) et d'une borne de second type de premier côté (5b), l'une d'elles servant de borne d'alimentation et l'autre servant de borne de terre, et d'une borne de signal de premier côté (5s) ; et
un second réseau de bornes (7) qui est formé sur une seconde surface principale du noyau de carte (100), et se compose d'une borne de premier type de second côté (7a) et d'une borne de second type de second côté (7b) qui sont respectivement conductrices avec la borne de premier type (5a) et la borne de second type (5b) de premier côté, et d'une borne de signal de second côté (7s) qui est conductrice avec la borne de signal de premier côté (5s),
dans lequel le premier réseau de bornes (5) est formé dans une position où il chevauche une zone de projection de la partie sous-noyau (1) dans une projection orthographique par rapport à une surface de référence parallèle à une surface de plaque du noyau de carte (100),
**caractérisée en ce que** la partie logement de sous-noyau (100h) a un bord périphérique intérieur d'une coupe transversale le long du plan parallèle à une surface de plaque de la partie sous-noyau (1) qui se compose uniquement d'une partie incurvée (B) ayant un rayon de courbure ne faisant pas moins de 0,1 mm qui est convexe vers l'extérieur,
dans laquelle la partie sous-noyau (1) a un bord périphérique extérieur de la coupe transversale le long du plan parallèle à la surface de plaque de la partie sous-noyau (1) de forme carrée, et une partie rayon (1c(r)) ou une partie chanfreinée (1c(t)) d'une dimension ne faisant pas moins de 0,1 mm mais ne dépassant pas 2 mm est formée sur ses coins, ou
dans laquelle la partie sous-noyau (1) a un bord périphérique extérieur de la coupe transversale le long du plan parallèle à la surface de plaque de la partie sous-noyau (1) se composant uniquement d'une partie incurvée (B') ayant un rayon de courbure ne faisant pas moins de 0,1 mm qui est convexe vers l'extérieur.

3. Carte de câblage selon la revendication 1 ou 2, dans laquelle la partie sous-noyau (1) comporte un condensateur stratifié (2) où une première couche conductrice d'électrode (51a) qui est conductrice avec la borne de premier type de premier côté (5a) et la borne de premier type de second côté (7a), une couche diélectrique (13), et une seconde couche conductrice d'électrode (51b) qui est conductrice avec la borne de second type de premier côté (5b) et la borne de second type de second côté (7b) sont stratifiées dans cet ordre.

4. Carte de câblage selon la revendication 2, dans laquelle la partie logement de sous-noyau (100h) a un bord périphérique intérieur de la coupe transversale d'une forme circulaire (C).

5. Carte de câblage selon l'une quelconque des revendications 1 à 4, dans laquelle le bord périphérique extérieur de la coupe transversale de la partie sous-noyau (1) a une forme circulaire (C').

6. Carte de câblage selon l'une quelconque des revendications 1 à 5, dans laquelle le premier réseau de bornes (5) est formé dans la position où il est entièrement inclus dans la zone de projection de la partie sous-noyau (1) dans une projection orthographique par rapport à la surface de référence parallèle à la surface de plaque du noyau de carte (100),

7. Carte de câblage selon l'une quelconque des revendications 1 à 6, dans laquelle le noyau de carte (100) est constitué de sorte que la première surface principale de la partie sous-noyau (1) ainsi que la première surface principale du corps principal de noyau (100m) soient recouvertes d'une première partie stratifiée de câblage (61) où une couche diélectrique (102) composée d'un matériau macromoléculaire et une couche conductrice (108) comprenant le câblage ou un conducteur de surface pour terre ou alimentation sont stratifiées, et le premier réseau de bornes (5) est exposé depuis la première surface principale de la première partie stratifiée de câblage (61).

8. Carte de câblage selon la revendication 7, dans laquelle un conducteur de sous-noyau de premier type (51a) et un conducteur de sous-noyau de second type (51b), qui correspondent respectivement à la borne de premier type de premier côté (5a) et à la borne de second type de premier côté (5b) du premier réseau de bornes (5) et sont respectivement conductrices avec la borne de premier type de second côté (7a) et la borne de second type de second côté (7b) du second ensemble de bornes (7) sont formées dans une direction dans le sens de l'épaisseur de la partie sous-noyau (1), et le conducteur de sous-noyau de premier type (51a) et le conducteur de sous-noyau de second type (51b) sont respectivement conducteurs avec la borne de premier type de premier côté (5a) et la borne de second type de premier côté (5b) par l'intermédiaire d'un conducteur d'interconnexion (107) formé de manière à percer les couches diélectriques (102) de la première partie stratifiée de câblage (61).

9. Carte de câblage selon la revendication 7 ou 8, dans laquelle :
dans le premier réseau de bornes (5), la borne de premier type de premier côté (5a) et la borne de second type de premier côté (5b) sont agencées dans une zone intérieure de réseau, et la borne de signal de premier côté (5s) est agencée dans une zone extérieure de réseau,
un câblage de signal de premier côté (108) destiné à faire sortir un chemin de transmission de signal vers l'extérieur d'une zone d'agencement de la partie sous-noyau (1) est disposé dans la première partie stratifiée de câblage (61) de manière à être conducteur avec la borne de signal de premier côté (5s), et une extrémité du câblage de signal de premier côté (1) est conductrice avec un conducteur de trou débouchant de signal (109s) formé dans une direction dans le sens de l'épaisseur du corps principal de noyau (100m) de manière à contourner la partie sous-noyau (1).

10. Carte de câblage selon l'une quelconque des revendications 1 à 6, dans laquelle la borne de premier type de premier côté (5a) et la borne de second type de premier côté (5b) composant le premier réseau de bornes (5) sont exposées pour être formées sur la première surface principale de la partie sous-noyau (1), et le conducteur de sous-noyau de premier type (51a) et le conducteur de sous-noyau de second type (51b), qui correspondent à la borne de premier type de premier côté (5a) et à la borne de second type de premier côté (5b) du premier ensemble de bornes (5) et sont conductrices avec la borne de premier type de second côté (7a) et la borne de second type de second côté (7b) du second ensemble de bornes (7), sont formés dans la direction dans le sens de l'épaisseur de la partie sous-noyau (1).

11. Carte de câblage selon la revendication 10, dans laquelle
le bord périphérique extérieur de la première surface principale de la partie sous-noyau (1) ainsi que de la première surface principale du corps principal de noyau (100m) est recouvert d'une première partie stratifiée de câblage (61) où une couche diélectrique (102) composée d'un matériau macromoléculaire et une couche conductrice comprenant le câblage ou un conducteur de surface pour terre ou alimentation sont stratifiées, et la première borne de signal de premier côté (5s) est exposée pour être formée sur la surface de la première partie stratifiée de câblage (61),
le câblage de signal de premier côté (108) qui fait sortir le chemin de transmission de signal vers l'extérieur de la zone d'agencement de la partie sous-noyau (1) est disposé dans la première partie stratifiée de câblage (61) de manière à être conducteur avec la borne de signal de premier côté (5s), et l'extrémité du câblage de signal de premier côté (108) est conductrice avec un conducteur de trou débouchant de signal (109s) formé dans la direction dans le sens de l'épaisseur du corps principal de noyau (100m) de manière à contourner la partie sous-noyau (1).

12. Carte de câblage selon l'une quelconque des revendications 1 à 11, dans laquelle la partie sous-noyau (1) est formée de manière à avoir une zone qui est équivalente ou supérieure à celle de la zone de formation du premier réseau de bornes (5).

13. Carte de câblage selon l'une quelconque des revendications 1 à 12, dans laquelle la partie isolante de la partie sous-noyau (1) est principalement composée de céramique.

14. Carte de câblage selon la revendication 13, dans laquelle la céramique est de la céramique d'alumine ou de verre.

15. Carte de câblage selon l'une quelconque des revendications 1 à 14, dans laquelle la partie sous-noyau (1) se compose d'un condensateur en céramique stratifiée calcinée.

16. Carte de câblage selon la revendication 3, dans laquelle le condensateur stratifié (2) se compose d'un condensateur à film mince formé sur la surface principale de la partie sous-noyau (1).
